(19) **Europäisches Patentamt European Patent Office Office européen des brevets**

(11) **EP 4 589 663 A1**

(12) **EUROPEAN PATENT APPLICATION**
published in accordance with Art. 153(4) EPC

(43) Date of publication:
**23.07.2025 Bulletin 2025/30**

(21) Application number: **23865401.6**

(22) Date of filing: **07.09.2023**

(51) International Patent Classification (IPC):
*H01L 29/06* (2006.01)    *G06N 10/40* (2022.01)
*H01L 29/66* (2006.01)    *H01L 29/82* (2006.01)
*H10B 43/20* (2023.01)    *H10B 99/00* (2023.01)

(52) Cooperative Patent Classification (CPC):
**G06N 10/40; H10B 43/20; H10B 99/00;
H10D 48/30; H10D 48/40; H10D 62/10**

(86) International application number:
**PCT/JP2023/032697**

(87) International publication number:
**WO 2024/058046 (21.03.2024 Gazette 2024/12)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **13.09.2022 JP 2022145376**

(71) Applicant: **Teikyo University
Tokyo 173-8605 (JP)**

(72) Inventor: **TANAMOTO Tetsufumi
Utsunomiya-shi, Tochigi 320-8551 (JP)**

(74) Representative: **LLR
2, rue Jean Lantier
75001 Paris (FR)**

(54) **SEMICONDUCTOR QUANTUM DEVICE**

(57) A semiconductor quantum device according to the present disclosure includes a transistor structure portion having a source, a drain, and a gate, one or more quantum dot structure portions capable of localizing charges; and a qubit control current line capable of changing states of the charges in the quantum dot structure portions, in which the quantum dot structure portions and the qubit control current line are disposed in the same layer, and the transistor structure portion and the quantum dot structure portions are laminated in a lamination direction with respect to a substrate.

FIG. 1

**Description**

TECHNICAL FIELD

The present invention relates to a semiconductor quantum device.

Priority is claimed on Japanese Patent Application No. 2022-145376, filed September 13, 2022, the content of which is incorporated herein by reference.

BACKGROUND ART

Research and development on quantum computers and quantum annealing machines are progressing (refer to, for example, Non-Patent Documents 1 and 2). For example, an experimental example of a semiconductor quantity bit is described in Non-Patent Document 1. An experimental example of a quantum annealing machine using a superconductor is described in Non-Patent Document 2 and Patent Document 1. These technologies have already been commercialized.

As a technology related to quantum computers, the development of related technologies using superconductors has developed more than that of semiconductors. This is because the time (coherence time) required to maintain a quantum state is experimentally and relatively easily realized in a superconducting state without resistance. However, in a superconducting device according to the related art, it is difficult to achieve integration.

On the other hand, current computers are formed of a semiconductor such as silicon. Transistors used in current smartphones and the like are already formed with a gate length which is equal to or less than 15 nm. In the future, it is also expected that transistors formed with a gate length of 2 nm will be put into practical use (for example, refer to Non-Patent Document 3).

In existing semiconductor technologies, technologies related to integration have been used for decades. Therefore, it is expected to realize a quantum computer-related technology having high reliability and versatility by applying the existing semiconductor technologies to a process of creating a qubit. However, it has been generally considered that it is more difficult to maintain the coherence of spin or charge state in a semiconductor than in a superconductor. Therefore, further development is desired in the technologies in this field.

Citation List

Patent Documents

Patent Document 1: United States Patent Application No. 2016/0019468
Patent Document 2: PCT International Publication No. WO 2017/182826
Patent Document 3: Japanese Unexamined Patent Application, First Publication No. 2021-197436

Non-Patent Documents

Non-Patent Document 1: M. Veldhorst, C. H. Yang, J. C. C. Hwang, W. Huang, J. P. Dehollain, J. T. Muhonen, S. Simmons, A. Laucht, F. E. Hudson, K. M. Itoh, A. Morello & A. S. Dzurak "A two-qubit logic gate in silicon"-nature volume 526, pages410-414(2015)
Non-Patent Document 2: M. W. Johnson et al. "Quantum annealing with manufactured spins"-nature vol 473, pp.194-198 (2011).
Non-Patent Document 3: S. Mochizuki et al., "Stacked Gate-All-Around-nanosheetp FET with Highly Compressive Strained Si1-xGex Channel," 2020 IEEE International Electron Devices Meeting (IEDM), 2020, pp. 2.3.1-2.3.4.
Non-Patent Document 4: T. Tanamoto and K. Ono, "Compact spin qubits using the common gate structure of fin field-effect transistors", AIP Advances 11, 045004 (2021).
Non-Patent Document 5: K. Takeda, J. Kamioka, T. Otsuka, J. Yoneda, T.-nakajima, M. R. Delbecq, S. Amaha, G. Allison, T. Kodera, S. Oda, and S. Tarucha, "A fault-tolerant addressable spin qubit in a-natural silicon quantum dot", Sci. Adv. 2, e1600694 (2016)
Non-Patent Document 6: J. Taylor, H.A. Engel, et al. "Fault-tolerant architecture for quantum computation using electrically controlled semiconductor spins."-nature Phys 1, 177-183 (2005).
Non-Patent Document 7: A. G. Fowler, A. C. Whiteside, A. L. McInnes, and A. Rabbani, Phys. Rev. X 2, 041003 (2012).
Non-Patent Document 8: A. Matsuzawa, "Low-voltage and low-power circuit design for mixed analog digital systems in portable equipment," in IEEE Journal of Solid-State Circuits, vol. 29,-no. 4, pp. 470-480, (1994).
Non-Patent Document 9: N. Yoshioka, Y. Akagi, and H. Katsura, Phys. Rev. E 99, 032113 (2019).

SUMMARY OF INVENTION

Technical Problem

An object of the present invention is to provide a semiconductor quantum device that can be configured by applying an existing transistor technology and that is a basic constitutional unit of a quantum computer and a quantum annealing machine. Specifically, an object of the present invention is to provide a semiconductor quantum device that can be manufactured in current factory facilities while utilizing transistor structures according to the related art as much as possible and that can perform measurement easily.

Solution to problem

In order to achieve the above object, the present invention provides a semiconductor quantum device including a transistor structure portion configured to have a source, a drain, and a gate; one or more quantum dot structure portions configured to localize charges; and a qubit control current line configured to change states of the charges in the quantum dot structure portions, in which the quantum dot structure portions and the qubit control current line are disposed in the same layer, and the transistor structure portion and the quantum dot structure portions are laminated in a lamination direction with respect to a substrate.

Advantageous Effects of Invention

According to the present invention, it is possible to provide a semiconductor quantum device that can be configured by applying an existing transistor technology and that is a basic constitutional unit of a quantum computer and a quantum annealing machine. Specifically, according to the present invention, the semiconductor quantum device can be manufactured in current factory facilities while utilizing transistor structures according to the related art as much as possible and that can perform measurement easily.

BRIEF DESCRIPTION OF DRAWINGS

[FIG. 1] A cross-sectional view showing a configuration of a semiconductor quantum device viewed from a front direction according to a first embodiment.
[FIG. 2] A perspective view showing a configuration of a quantum dot structure portion according to the first embodiment.
[FIG. 3] A cross-sectional view showing a configuration of a semiconductor quantum device viewed from a front direction according to a second embodiment.
[FIG. 4] A cross-sectional view showing a configuration of semiconductor quantum device viewed from a side direction according to a third embodiment.
[FIG. 5] A perspective view showing a configuration of a semiconductor quantum device according to a fourth embodiment.
[FIG. 6] A cross-sectional view showing a configuration of a semiconductor quantum device viewed from a side direction according to a fifth embodiment.
[FIG. 7] A perspective view showing a configuration of a quantum dot structure portion according to a fifth embodiment.
[FIG. 8] A cross-sectional view showing a nanosheet structure viewed from a front direction according to a fifth embodiment.
[FIG. 9] A diagram showing a function of an external magnetic field showing energy levels of two qubits according to a sixth embodiment.
[FIG. 10] A diagram showing an RKKY interaction of a quantum dot structure portion according to a seventh embodiment.
[FIG. 11] A diagram showing an example in which a logical qubit is composed of four quantum dots according to the seventh embodiment.
[FIG. 12] A diagram showing a method of performing a quantum operation by changing the strength of the electrostatic coupling between nanosheets according to an eighth embodiment.
[FIG. 13] A diagram showing a semiconductor quantum device configured with a layout in which surface codes can be implemented according to a tenth embodiment.

[FIG. 14] A diagram showing an example in which a quantum operation is performed in order using a semiconductor quantum device according to the tenth embodiment.

[FIG. 15] A diagram showing a configuration of a semiconductor quantum device in which nanosheet-type qubits are connected in a horizontal direction according to an eleventh embodiment.

[FIG. 16] A diagram showing an interaction of an RKKY interaction of the quantum dot structure portion in the horizontal direction according to the eleventh embodiment.

[FIG. 17] A diagram showing a configuration in a case where quantum annealing is implemented in a semiconductor quantum device according to a twelfth embodiment.

[FIG. 18] A cross-sectional view showing a configuration of a semiconductor quantum device viewed from a front direction according to the twelfth embodiment.

[FIG. 19] A cross-sectional view showing a configuration of a semiconductor quantum device viewed from a front direction according to the twelfth embodiment.

[FIG. 20] A diagram showing a configuration of a semiconductor quantum device in a case where a qubit operation is performed in a three-dimensional NAND flash according to the fifteenth embodiment.

[FIG. 21] A diagram showing the directions of magnetic domains of a magnetic body applied to a semiconductor quantum device according to a sixteenth embodiment.

DESCRIPTION OF EMBODIMENTS

Before describing embodiments of a semiconductor quantum device according to the present invention, a technology related to the structure, measurement, and the like of a quantum device according to the related art will be described.

(Related art related to structure)

The quantum device includes a qubit that stores quantum information. A quantum device according to the related art is usually configured such that semiconductor qubits are disposed in parallel on a substrate. However, in the quantum device according to the related art, a large number of wirings are required to control the qubits. Therefore, in the quantum device according to the related art, there is a problem in that the interval between the wirings provided to individually access the qubits arranged in parallel on the substrate is close, and crosstalk that affects the adjacent wirings occurs.

Patent Document 3 and Non-Patent Document 4 propose a quantum dot structure in a two-dimensional in-plane Fin Field-Effect Transistor (FINFET) in which the number of wirings is reduced in a quantum device. However, in this structure, since the current line that generates a magnetic field and the structure of the qubit are spatially separated, a large amount of current needs to flow. In addition, Non-Patent Document 5 proposed a method in which a magnetic body is installed on the same substrate as the qubit and a magnetic field gradient is used. However, in this method, it is necessary to separate the distance between two or more qubits, so that there is a problem in integration.

(Related art related to logical qubit)

In a case where one logical qubit is formed from two or more charge spins, a method of the related art uses a method of directly using an analytical mathematical solution by strictly solving an eigen solution of a Heisenberg interaction Hamiltonian between the qubits. However, since a Heisenberg interaction has a complicated form, there is a disadvantage in that an arithmetic manipulation between logical qubits is extremely complicated.

(Quantum annealing technology)

Quantum annealing technology is related to artificial intelligence, and research has been developing as means for solving optimization problems. First, Nishimori et al. developed a physical theory, and research accelerated with the development and sale of D-wave in Canada (refer to Non-Patent Document 2 and Patent Document 1). Quantum annealing is a quantum extension of a classical annealing calculation method, and is expected to reduce calculation time for so-called NP-hard problems such as the traveling salesman problem. However, a method of logically connecting qubits over a long distance with a solid-state qubit requires a new connection structure, and there is a problem in reliability and the like.

In the present invention, by stacking the qubits in the vertical direction, it is possible to arrange wirings in parallel with respect to a substrate, and it is possible to reduce crosstalk between the wirings. In addition, in a method of forming a logical qubit according to the present invention, since the eigen states of a plurality of charge spins are used without change, it is not necessary to obtain an analytical solution, and since the plurality of charge spins are treated as the eigen states of the many-body interaction, a manipulation between the logical bits is possible with a voltage pulse corresponding to an energy difference between the eigen energy levels.

Hereinafter, an embodiment of a semiconductor quantum device according to the present invention will be described with reference to the drawings.

[First embodiment]

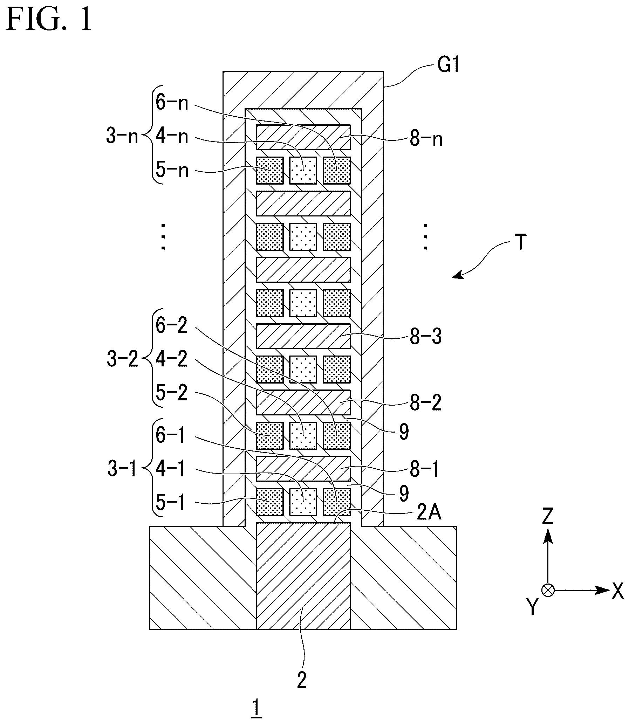

As shown in FIG. 1, a semiconductor quantum device 1 includes a plate-like substrate 2, a transistor structure portion T provided on an upper layer side of the substrate 2, and one or more quantum dot structure portions 3-n (n: natural number) provided in the transistor structure portion T. The quantum dot structure portion 3-n is configured to be able to localize charges. The transistor structure portion T has a source, a drain, and a gate G1. In the transistor structure portion T, for example, a source is provided on the front side of the paper surface in the drawing. In the transistor structure portion T, for example, a drain is provided on a back side of the paper surface in the drawing. The source and the drain may be interchanged.

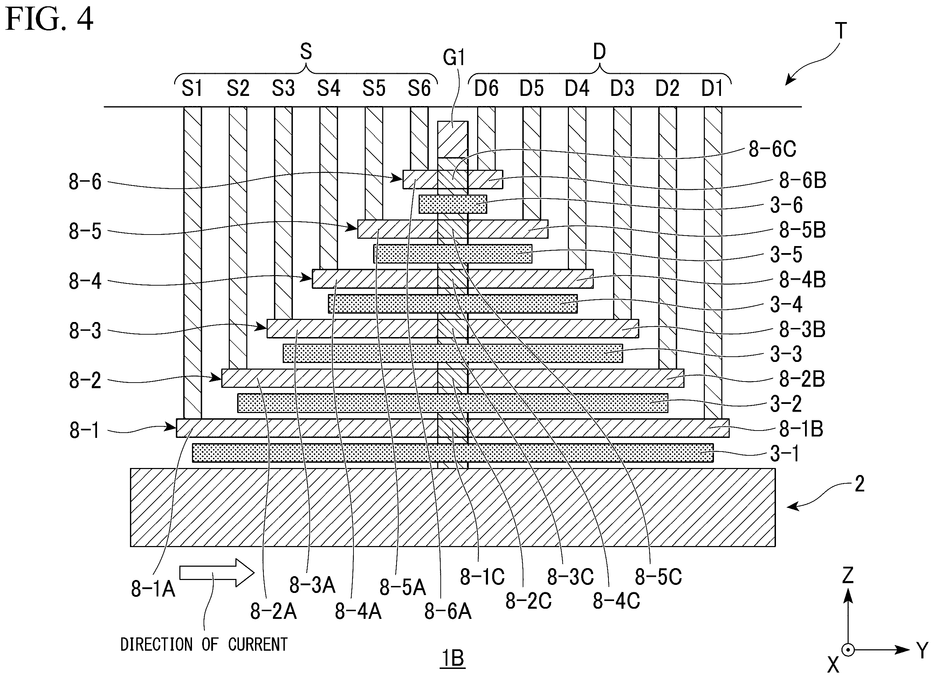

The substrate 2 is formed of, for example, a silicon material (refer to FIG. 4). The transistor structure portion T has, for example, a plurality of sheet-like conductive portions (channel structure portions 8-n) for conducting charge, which connect a source and a drain and are formed in a sheet shape. The sheet-like conductive portion is composed of a source electrode portion 8-nA, a drain electrode portion 8-nB, and a conductive channel portion 8-nC adjacent to the gate G1 (refer to FIG. 4). The sheet-like conductive portion is generally referred to as a nanosheet, a nanowire, a nanoribbon, or a fork sheet structure, but will be referred to as a channel structure portion 8-n for simplicity.

The plurality of channel structure portions 8-n are laminated on the substrate 2 in a lamination direction (Z-axis direction). The quantum dot structure portion 3-n is provided between the channel structure portions 8-n adjacent to each other in the lamination direction. That is, a plurality of quantum dot structure portions 3-n are provided between the plurality of channel structure portions 8-n. It is particularly efficient to provide the quantum dot structure portion 3-n at an adjacent position in the vicinity of the conductive channel portion 8-nC adjacent to the gate G1, particularly, in the channel structure portion 8-n. The transistor structure portion T and the quantum dot structure portion 3-n are laminated in a lamination direction with respect to the substrate 2. A portion in the drawing in which the component is not described (that is, a space portion in the drawing) is appropriately filled with, for example, an insulating layer 9. The insulating layer 9 is provided between the channel structure portion 8-n and the quantum dot structure portion 3-n.

The transistor structure portion T is a nanosheet-type transistor having the plurality of channel structure portions 8-n sandwiching the quantum dot structure portion 3-n. The gate G1 extends in the periphery of the plurality of quantum dot structure portions 3-n in a layer direction. That is, the gate G1 is disposed in the periphery of the transistor structure portion T. The gate G1 is adjacent to the conductive channel portion 8-nC in the channel structure portion 8-n of each layer. The gate G1 is adjacent to the conductive channel portion 8-nC (refer to FIG. 4) in the channel structure portion 8-n. The gate G1 controls a voltage to be applied to generate an electric field, controls the density of electrons or holes generated in the conductive channel portion 8-nC, and controls the current between the drain and the source in the substrate 2.

Each channel structure portion 8-n is connected to a source contact wiring Sn for a source electrode and a drain contact wiring Dn for a drain electrode, the source contact wiring Sn for the source electrode being connected to the source electrode portion 8-nA and the drain contact wiring Dn for the drain electrode being connected to the drain electrode portion 8-nB. On the upper layer side of the substrate 2, a plurality of channel structure portions 8-n, a gate G1, and a source and a drain form a nanosheet structure. The quantum dot structure portion 3-n includes at least one quantum dot 4-n and a pair of qubit control current lines 5-n and 6-n that are disposed on both sides of the quantum dot 4-n. Electrons or holes can be accumulated in the quantum dots 4-n in each quantum dot structure portion 3-n. The quantum dot 4-n is formed of, for example, a material, such as polysilicon, capable of accumulating charges.

In addition, the quantum dot 4-n may be artificially created or may be naturally created, such as a defect. The energy level of the quantum dot 4-n may be a trap level. There are two types of the channel structure portion 8-n, which are an n-type semiconductor and a p-type semiconductor. In many cases, the impurity concentration in the source and drain portions is higher than that in the portion under the gate.

Each quantum dot structure portion 3-n includes, for example, at least one quantum dot 4-n that functions as a qubit, and a pair of qubit control current lines 5-n and 6-n that can change a charge state in the quantum dot structure portion 3-n. In the quantum dot structure portion 3-n, the qubit control current lines 5-n and 6-n are disposed in the same layer.

A qubit control current, which generates a magnetic field for controlling a spin state of an electron or a hole in the quantum dot structure portion 3-n, flows through the qubit control current lines 5-n and 6-n. The qubit control current lines 5-n and 6-n are disposed close to the quantum dots 4-n. The semiconductor quantum device 1 is a device in which quantum dots 4-n serving as qubits and qubit control current lines 5-n and 6-n for controlling the qubits are installed between the nanosheet structures having a plurality of channel structure portions 8-n.

The substrate 2 is formed of, for example, a silicon material. The substrate 2 is formed in a rectangular plate-like body. In the drawing, a longitudinal direction of the substrate 2 is formed along the Y direction, and a lateral direction (width direction) of the substrate 2 is formed along the X direction. A first layer of the quantum dot structure portion 3-1 is formed on the upper surface side of the substrate 2 via the insulating layer 9 interposed therebetween. The insulating layer 9 is formed of, for example, an insulator such as SiO2.

In the quantum dot structure portion 3-1, at least one quantum dot 4-1 is disposed in the center portion viewed in a cross section in the Y direction and viewed from a side in the X direction. The number and disposition relationship of the quantum dots 4-1 will be described later. The quantum dot 4-1 is formed of, for example, a material, such as polysilicon, capable of accumulating charges. In a case of being viewed in cross section in the Y direction, a pair of qubit control current lines 5-1 and 6-1 are disposed on both sides of the quantum dot 4-1. The pair of qubit control current lines 5-1 and 6-1 are formed of, for example, a conductive material such as Cu. The pair of qubit control current lines 5-1 and 6-1 can generate a magnetic field in the periphery based on the flowing current to change the state of the charge in the quantum dot 4-1.

Specifically, a qubit control current, which generates a magnetic field for controlling an electron or a hole, flows through the pair of qubit control current lines 5-1 and 6-1. In addition, by causing an alternating current to flow through the qubit control current lines 5-1 and 6-1, the position of the charge in the quantum dot 4-n, which is the qubit, is vibrated, thereby being used to affect the charge with a substantial change in the magnetic field.

The qubit control current line 5-1 is disposed on one side in the X-axis direction viewed in cross section in the Y direction. The qubit control current line 5-1 is formed of, for example, a general metal wiring such as polysilicon, copper, aluminum, tantalum, tungsten, or a composite material including these. The qubit control current line 5-1 is formed to extend in the Y-axis direction as viewed from a side in the X-axis direction.

The qubit control current line 6-1 is disposed on the other side in the X-axis direction viewed in cross section in the Y direction. The qubit control current line 6-1 is formed of, for example, a metal wiring. The qubit control current line 6-1 is formed to extend in the Y-axis direction as viewed from a side in the X-axis direction. The qubit control current line 6-1 is formed to be symmetrical to the quantum dot 4-1 with respect to the qubit control current line 5-1 in a case of being viewed along the Y-axis direction. With this configuration, the quantum dot structure portion 3-1 is formed. On the upper layer side of the quantum dot structure portion 3-1, a first layer of the channel structure portion 8-1 is formed via the insulating layer 9.

The channel structure portion 8-1 is formed of, for example, a silicon material. A composite material such as silicon germanium (SiGe) may be used as the silicon material. The channel structure portion 8-1 is formed in a rectangular plate-like body. In the drawing, a longitudinal direction of the channel structure portion 8-1 is formed along the Y direction, and a lateral direction (width direction) of the channel structure portion 8-1 is formed along the X direction. A second layer of the quantum dot structure portion 3-2 is formed on the upper surface side of the channel structure portion 8-1 via the interposition of the insulating layer 9.

The quantum dot structure portion 3-2 has the same configuration as the quantum dot structure portion 3-1. The quantum dot structure portion 3-2 includes at least one quantum dot 4-2 and a pair of qubit control current lines 5-2 and 6-2 disposed on both sides of the quantum dot 4-2.

The qubit control current line 6-2 is formed to extend in the Y-axis direction as viewed from a side in the X-axis direction. The qubit control current line 6-2 is formed to be symmetrical to the quantum dot 4-2 with respect to the qubit control current line 5-2 in a case of being viewed along the Y-axis direction. With this configuration, the quantum dot structure portion 3-2 is formed. On the upper layer side of the quantum dot structure portion 3-2, a second layer of the channel structure portion 8-2 is formed via the insulating layer 9.

The channel structure portion 8-2 is formed of, for example, a silicon material. The channel structure portion 8-2 is formed in a rectangular plate-like body. The channel structure portion 8-2 has the same configuration as the channel structure portion 8-1. On the upper layer side of the channel structure portion 8-2, a third layer of the quantum dot structure portion 3-3 is formed via an insulating layer 9, similarly to the configuration. On the upper layer side of the quantum dot structure portion 3-3, a third layer of the channel structure portion 8-3 is formed via the insulating layer 9.

In the semiconductor quantum device 1, the same configuration as described above is repeated, and -n is set to any number, where -n is an n-th layer of the quantum dot structure portion 3-n and an n-th layer of the channel structure portion 8-n. In the example of the present embodiment, the semiconductor quantum device 1 is formed with a sixth layer of the quantum dot structure portion 3-6 and a sixth layer of the channel structure portion 8-6. The gate G1 is an electrode common to an n-th layer of the quantum dot structure portion 3-n and an n-th layer of the channel structure portion 8-n. The gate G1 is formed in a gate shape to cover the peripheries of the n-th layer of the quantum dot structure portion 3-n and the n-th layer of the channel structure portion 8-n. In the example shown in the drawing, the gate G1 is formed in a gate shape to cover the periphery of the n-th layer of the quantum dot structure portion 3-n and the n-th layer of the channel structure portion 8-n, but the gate G1 may be disposed on any of the lateral side or the lower side of the channel structure portion 8-n.

With this configuration, in the semiconductor quantum device 1, the interaction of each of the qubits (quantum dots 4-n) laminated in the lamination direction is executed through the nanosheet structure formed by the substrate 2 and each channel structure portion 8-n. In the semiconductor quantum device 1, by installing the qubit control current lines 5-n and 6-n, which control the qubits (quantum dots 4-n), adjacent to the immediate vicinity of the qubits, a large magnetic field can be generated with a smaller current.

The semiconductor quantum device 1 includes nanosheets obtained by laminating channels for measuring the operation results of the quantum dots 4-n in a layer direction. With this configuration, the semiconductor quantum device 1 corresponds to the Fin Field-Effect Transistor (FINFET) structure of Non-Patent Document 4.

The operation principle of the semiconductor quantum device 1 as the semiconductor quantum device can have a detailed structure based on the FINFET structure of Non-Patent Document 4. In the FINFET structure, when a voltage is applied to the gate G1, charges accumulate in the channel structure portion 8-n (charge conduction path) between the source and the drain due to the electric field effect of the gate G1, thereby forming an inversion layer.

In the interaction between qubits of the quantum dot structure portions 3-n and 3-n-1 adjacent to each other in the lamination direction, charges accumulate in a portion near the gate G1 of the channel structure portion 8-n-1, thereby forming the inversion layer. The charges accumulated near the surface in the channel are used for the interaction between the qubits of the quantum dot structure portions 3-n and 3-n-1 adjacent to each other in the lamination direction.

The insulating layer 9 between the quantum dot structure portion 3-n-1 and the channel structure portion 8-n-1 and the insulating layer 9 between the quantum dot structure portion 3-n and the channel structure portion 8-n-1 are made sufficiently thin. For example, in a case where the insulating layer 9 is a silicon oxide film, the thickness of the insulating layer 9 is equal to or less than 2 nm. In this case, quantum mechanical tunneling occurs between the quantum dot 4-n-1 and the channel structure portion 8-n-1, and between the quantum dot 4-n and the channel structure portion 8-n-1. Via the tunneling phenomenon, the charge spins in the two quantum dots 4-n and 4-n-1 on both sides of the channel structure portion 8-n-1 form an interaction. This is generally referred to as a Ruderman Kittel Kasuya Yoshida (RKKY) interaction, and here, it indicates an interaction between the qubits via the charge of the channel structure portion.

Tunneling through the thin film occurs between the spin in the quantum dot 4-n and the charge of the conduction channel (channel structure portion 8-n-1). Additionally, the tunneling through the thin film also occurs between the spin in the quantum dot 4-n-1 and the charge of the conduction channel (channel structure portion 8-n-1). The charge in the quantum dot 4-n interacts with the charge in the channel structure portion 8-n-1 through this tunneling, and the conductive charge can move in the channel structure portion 8-n-1, so that the charge reaches the opposite side of the channel structure portion 8-n-1. Here, the interaction with the spin in another quantum dot 4-n-1 is made through tunneling again. In this way, the interaction of charges in the quantum dots 4-n and 4-n-1 via the movement of the charges in the channel structure portion 8-n-1, that is, qubits is a specific description of the RKKY interaction. Table 1 shows an example of a manipulation (operation) corresponding to a manipulation mode, a measurement mode, and the like of the qubit.

[Table 1]

| TABLE I. Operaion in QD-FINFET | | | | |
|---|---|---|---|---|
| operations | $I_{ctrl}$ | $V_G$ | $V_S, V_D$ | Magnetic field |
| memory | 0 | $V_G > 0$ | $V_s = V_D \neq 0$ | $Bz \neq 0$ |
| qubit manipulation | $\neq 0$ | $V_G > 0$ | $V_S = V_D \neq 0$ | $Bz \neq 0$ |
| measurement | 0 | $V_G > 0$ | $V_S < V_D$ | $Bz \neq 0$ |

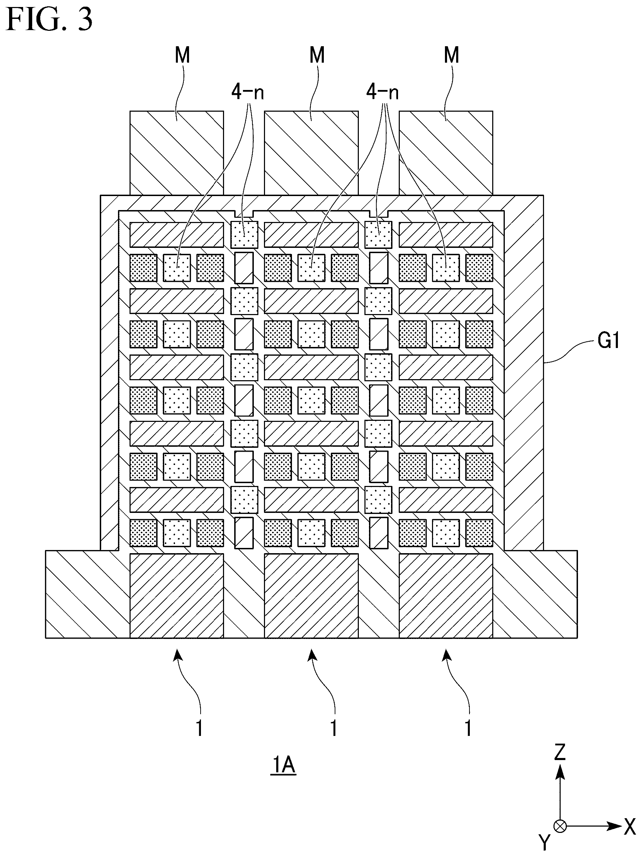

In the examples shown in Table 1, in the manipulation mode of the qubit (quantum dot 4-n), the current $I_{ctrl}$ of the qubit control current lines 5-n and 6-n (refer to FIG. 1) is set to a value that is not zero, the voltage $V_G$ of the gate G1 (refer to FIG. 1) is set to a value that is greater than zero, the voltage $V_S$ of the source (refer to FIG. 1) is set to a value that is not zero, the voltage $V_D$ of the drain (refer to FIG. 1) is set to a value that is not zero, and the transverse magnetic field generated by the qubit control current lines 5-n, 6-n, and the like is set to a value that is not zero. In addition, a magnetic field $B_Z$ generated by magnetic field-generating means (refer to the magnetic body M in FIG. 3) other than the qubit control current lines 5-n and 6-n is set to a value that is not zero.

In the measurement mode of the qubits (quantum dots 4-n), the current $I_{ctrl}$ of the qubit control current lines 5-n and 6-n is set to zero, the voltage $V_G$ of the gate G1 is set to a value greater than zero, and the voltage $V_S$ of the source is set to a value smaller than the voltage $V_D$ of the drain. As a result, a current flows between the source and the drain. Additionally, the states of the charge spins in the quantum dot 4-n are estimated based on the current between the source and the drain. In addition, the voltage $V_S$ may be higher than the voltage $V_D$ depending on the symmetry of a circuit. In addition, the magnetic field $B_Z$ generated by the magnetic field-generating means other than the qubit control current lines 5-n and 6-n is set to a value that is not zero.

In the memory mode of the qubits (quantum dot 4-n), the currents $I_{ctrl}$ of the qubit control current lines 5-n and 6-n are set to zero, the voltage $V_G$ of the gate G1 is set to a value greater than zero, the voltage $V_S$ of the source is set to a value that is not zero, and the voltage $V_D$ of the drain is set to a value that is not zero. In addition, the magnetic field $B_Z$ generated by the magnetic field-generating means other than the qubit control current lines 5-n and 6-n is set to a value that is not zero.

The semiconductor quantum device 1 includes the plurality of nanosheet-like channel structure portions 8-n through which a current flows between the source and the drain. The quantum dot structure portion 3-n is provided between the layers of the channel structure portion 8-n. Each quantum dot structure portion 3-n is provided with the quantum dot 4-n into which an electron or a hole is injected and the qubit control current lines 5-n and 6-n adjacent to the quantum dot 4-n.

In the example shown in the drawing, the semiconductor quantum device 1 uses the spin of the countable electron or hole accumulated in the quantum dot 4-n as a qubit, which is a basic unit. In addition, the charge used in the semiconductor quantum device 1 means an electron or a hole. In the case of holes, the polarity of an electrode applied is opposite to that of electrons. However, since the explanation is the same, charges will be mainly described below.

The quantum dot structure portion 3-n is provided with at least two layers of the first quantum dot structure portion and the second quantum dot structure portion which are laminated to be adjacent to each other in the lamination direction. A first channel structure portion included in the plurality of channel structure portions 8-n is disposed between the first quantum dot structure portion and the second quantum dot structure portion. By using a magnetic field generated by flowing a qubit control current through the qubit control current lines 5-n and 6-n, the quantum state of the charge spin in the first quantum dot structure portion is changed, and the interaction between the charge spin in the first quantum dot structure portion and the charge spin in the second quantum dot structure portion is set as an indirect interaction via the charge in the first channel structure portion.

In the semiconductor quantum device 1, the quantum dot 4-n uses the spin of the charge. The direction of the spin of the charge in the quantum dot 4-n corresponds to the quantum state ($|\uparrow>$ and $|\downarrow>$). The quantum state of the charge spin is changed based on an external magnetic field. As the external magnetic field, two types of magnetic fields are used, that is, a static magnetic field applied to the entire semiconductor quantum device 1 and a dynamic magnetic field generated by flowing a current in the qubit control current lines 5-n and 6-n. As shown in a second embodiment, for example, a magnetic body M (refer to FIG. 3) may be used as the static magnetic field applied to the entire semiconductor quantum device 1. In the case of the second embodiment, by flowing an alternating current or a pulse current through the qubit control current lines 5-n and 6-n, and vibrating the position of the charge in the quantum dot, the same situation as the case where an effective magnetic field is applied can be created. The static magnetic field may be generated based on a current in addition to the magnetic body M.

In a case where a static external magnetic field is applied, the spin of the charge in the quantum dot 4-n undergoes Zeeman separation depending on the direction. For example, when an upward magnetic field is applied, the spins tend to be aligned along the magnetic field. Therefore, the energy of an upward spin is high, and the energy of a downward spin is low. Accordingly, it is possible to distinguish between the spin states. A magnetic field of, for example, about 1 T (Tesla) to several T is used experimentally. The magnitude of the dynamic magnetic field can be estimated using Ampere's law. In the semiconductor quantum device 1, a manipulation of setting the quantum dot 4-n to a state between $|0>$ and $|1>$ is performed based on the wiring structure.

In the semiconductor quantum device 1, the quantum dots 4-n in the upper layer and the lower layer in the nanosheet structure interact with each other via an interaction with the charge in the nanosheet structure. In the semiconductor quantum device 1, a Controlled-NOT (CNOT) gate operation or the like is performed based on the interaction between the nanosheets. The CNOT gate is a gate having a function of maintaining a state in a case where the control bit is $|0>\}$ and inverting $|0>\}$ and $|1>\}$ of the target bits in a case where the control bit is $|1>\}$.

In the present embodiment, in the semiconductor quantum device 1, the plurality of laminated channel structure portions 8-n connected to the source and the drain are called nanosheets, but another name may be used in general. In the semiconductor quantum device 1, one or more quantum dots 4-n are sandwiched between the nanosheets laminated in the lamination direction on the substrate 2.

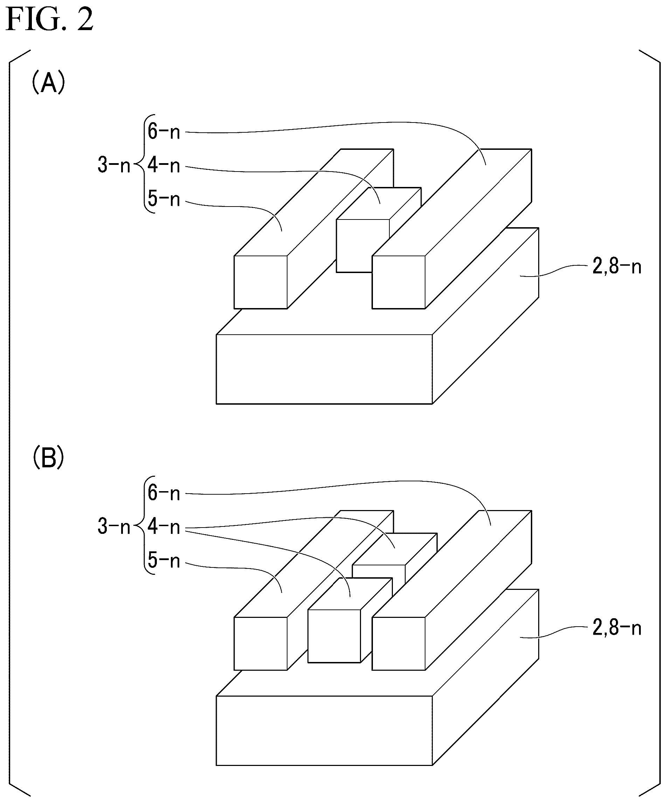

As shown in (A) of FIG. 2, in the semiconductor quantum device 1, in a case where one quantum dot 4-n is present, the qubit is composed of a charge in the quantum dot 4-n. As shown in (B) of FIG. 2, in a case where there are a plurality of quantum dots 4-n in the semiconductor quantum device 1, the qubit can be used as a logical qubit composed of a plurality of quantum dots 4-n described later. The quantum dots 4-n are fine structures, and may be composed of a floating gate or a trap level.

[Second embodiment]

Hereinafter, a semiconductor quantum device 1A according to the second embodiment will be described. In the following description, the same configurations as in the first embodiment have the same names and reference numerals, and redundant description thereof will be appropriately omitted. A semiconductor quantum device 1A of the second embodiment is configured in the same manner as the semiconductor quantum device 1 of the first embodiment, except for the description below. Therefore, according to the semiconductor quantum device 1A of the second embodiment, the same effects as in the above-described semiconductor quantum device 1 of the first embodiment can be obtained except for the description below.

As shown in FIG. 3, the semiconductor quantum device 1A includes a plurality of semiconductor quantum devices 1 disposed in parallel in the X-axis direction, a gate G1 formed to surround the periphery of the plurality of semiconductor quantum devices 1, and one or more magnetic bodies M provided on an upper portion of the gate G1 to correspond to each semiconductor quantum device 1. In the shown example, three semiconductor quantum devices 1 are disposed in parallel. In the semiconductor quantum device 1A, two or three or more semiconductor quantum devices 1 may be provided. The quantum dots 4-n are further disposed between the semiconductor quantum devices 1 to correspond to the positions of the quantum dots 4-n in each layer of the nanosheet structure.

The magnetic body M is formed of, for example, a tiny nano magnet that generates a magnetic field. Each magnetic body M applies a magnetic field to a space including each semiconductor quantum device 1. One or more magnetic bodies M installed close to the transistor structure portion T generate a magnetic field for controlling the spin state of the electron or the hole in the quantum dot structure portion 3-n. According to the semiconductor quantum device 1A, by using the magnetic field generated by the magnetic body M, each quantum dot 4-n in each quantum dot on each layer of each quantum dot structure portion 3-n in the nanosheet structure can be individually controlled.

In a case where a magnetic field generated by the magnetic body M is present and an electric field, such as an alternating current or a pulse, is applied to the quantum dots 4-n disposed between the qubit control current lines 5-n and 6-n by the qubit control current lines 5-n and 6-n of each layer in the nanosheet structure, the spin in the quantum dot 4-n moves in the quantum dot 4-n, thereby achieving the same effect as when the magnetic field is changed. In the present embodiment, by installing the qubit control current lines 5-n and 6-n that apply a voltage change to the quantum dot 4-n immediately next to the qubit, it is possible to perform control using a gradient magnetic field by the magnetic body M with a small current.

The example of FIG. 3 exemplifies a structure in which the magnetic body M having the same size as the nanosheet is disposed on the upper side of the nanosheet structure, but the size of the magnetic body M does not need to be matched to the width of the nanosheet, and the magnetic body M may be disposed inside the nanosheet or the like as long as the gradient magnetic field can be generated.

As described in the first embodiment and the second embodiment, the qubit control current lines 5-n and 6-n adjacent to the quantum dot 4-n can be used for both the generation of the magnetic field and the generation of the high-frequency electric field. In the following embodiment, the qubit control current lines 5-n and 6-n are also referred to as an electric field control and magnetic field generation lines.

[Third embodiment]

Hereinafter, a semiconductor quantum device 1B according to a third embodiment will be described. In the following description, the same configurations as in the first embodiment have the same names and reference numerals, and redundant description thereof will be appropriately omitted. A semiconductor quantum device 1B of a third embodiment is configured in the same manner as the semiconductor quantum device 1 of the first embodiment, except for the description below. Therefore, according to the semiconductor quantum device 1B of the third embodiment, the same effects as in the above-described semiconductor quantum device 1 of the first embodiment can be obtained except for the description below.

FIG. 4 shows a semiconductor quantum device 1B according to the third embodiment. FIG. 4 shows a semiconductor quantum device 1B, which has a structure for controlling qubits sandwiched between channel structure portions 8-n as viewed from a side. In the semiconductor quantum device 1B, the source and the drain are independently installed for each channel structure portion, and the interaction between the qubits can be controlled by the potential of the source and the drain.

A source contact wiring Sn is connected to a source electrode portion 8-nA of each channel structure portion 8-n, and a source electrode portion 8-nA of each channel structure portion 8-n is connected to a drain electrode portion 8-nB of each channel structure portion 8-n. The source contact wiring Sn and the drain contact wiring Dn are formed in a symmetrical structure and may be interchanged.

In the channel structure portion 8-1, a source contact wiring S1 that stands upward and a drain contact wiring D1 that stands upward are formed. In the channel structure portion 8-2, a source contact wiring S2 that stands upward and a drain contact wiring D2 that stands upward are formed. In the channel structure portion 8-n laminated in the same lamination direction as in the above configuration, the source contact wiring Sn and the drain contact wiring Dn that stand upward are formed.

The length of the qubit control current line 5-1 in the Y-axis direction is slightly shorter than the interval between the source contact wiring S1 and the drain contact wiring D1. The length of the qubit control current line 5-2 in the Y-axis direction is slightly shorter than the interval between the source contact wiring S2 and the drain contact wiring D2. The qubit control current lines 5-n are repeatedly formed in the lamination direction in the same manner as the above configuration.

The length of the qubit control current line 6-1 in the Y-axis direction is slightly shorter than the interval between the source contact wiring S1 and the drain contact wiring D1. The length of the qubit control current line 6-2 in the Y-axis direction is slightly shorter than the interval between the source contact wiring S1 and the drain contact wiring D1. The qubit control current lines 6-n are repeatedly formed in the lamination direction in the same manner as the configuration.

[Fourth embodiment]

Hereinafter, a semiconductor quantum device 1C according to a fourth embodiment will be described. In the following description, the same configurations as in the first embodiment have the same names and reference numerals, and redundant description thereof will be appropriately omitted. A semiconductor quantum device 1C of the fourth embodiment is configured in the same manner as the semiconductor quantum device 1 of the first embodiment, except for the description below. Therefore, according to the semiconductor quantum device 1 of the fourth embodiment, the same effects as in the above-described semiconductor quantum device 1 of the first embodiment can be obtained except for the description below.

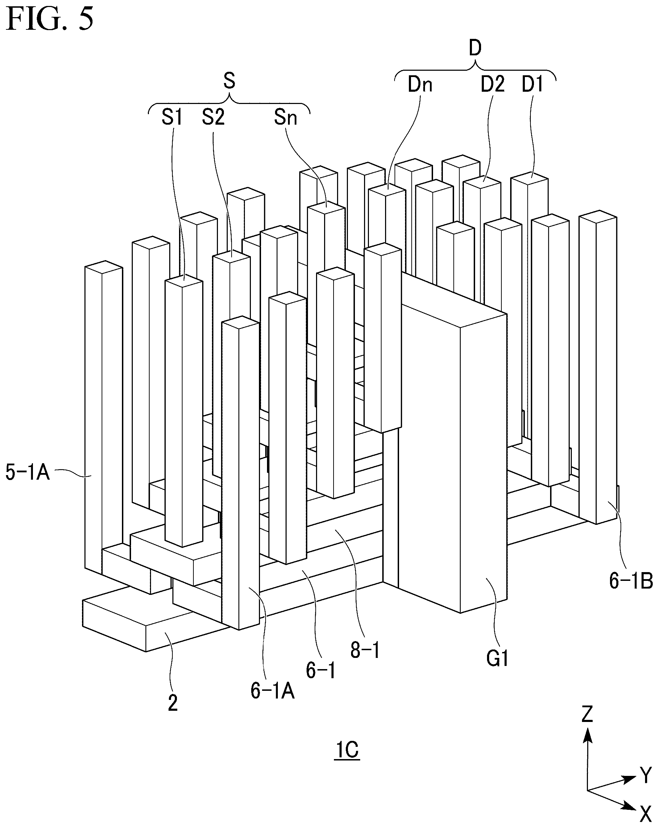

FIG. 5 is a perspective view showing a configuration of a semiconductor quantum device 1C according to the fourth embodiment. A source contact wiring S1 that stands upward is formed on a source electrode portion 8-1A side on one side in the Y-axis direction in the longitudinal direction of the first layer of the channel structure portion 8-1. A drain contact wiring D1 that stands upward is formed on a drain electrode portion 8-1B side on one side in the Y-axis direction in the longitudinal direction of the channel structure portion 8-1. The source contact wiring S1 and the drain contact wiring D1 are formed in a symmetrical structure and may be interchanged.

In the first layer of the quantum dot structure portion 3-1, a power supply wiring 5-1A that stands toward the upper layer side is formed at an end portion of the qubit control current line 5-1 on one side in the Y-axis direction. The lower end portion of the power supply wiring 5-1A is bent in the X-axis direction and is electrically connected to the end portion of the qubit control current line 5-1 on one side in the Y-axis direction. The length of the qubit control current line 5-1 in the Y-axis direction is slightly shorter than the interval between the source contact wiring S1 and the drain contact wiring D1.

In the first layer of the quantum dot structure portion 3-1, a power supply wiring 6-1B (not shown) that stands toward the upper layer side is formed at an end portion of the qubit control current line 6-1 on the other side in the Y-axis direction. The power supply wiring 6-1B is formed in the same shape as the power supply wiring 6-1A. The lower end portion of the power supply wiring 6-1B is bent in the X-axis direction and is electrically connected to an end portion of the qubit control current line 6-1 on the other side in the Y-axis direction. The length of the qubit control current line 6-1 in the Y-axis direction is slightly shorter than the interval between the source contact wiring S1 and the drain contact wiring D1.

A source contact wiring S2 that stands upward is formed on a source electrode portion 8-2A side on one side in the Y-axis direction in the longitudinal direction of the second layer of the channel structure portion 8-2. A drain contact wiring D2 that stands upward is formed on a drain electrode portion 8-2B side on one side in the Y-axis direction in the longitudinal direction of the channel structure portion 8-2. The source contact wiring S2 and the drain contact wiring D2 are formed in a symmetrical structure and may be interchanged.

In the second layer of the quantum dot structure portion 3-2, a power supply wiring 5-2A that stands toward the upper layer side is formed at an end portion of the qubit control current line 5-2 on one side in the Y-axis direction. The lower end portion of the power supply wiring 5-2A is bent in the X-axis direction and is electrically connected to an end portion of the qubit control current line 5-2 on one side in the Y-axis direction. The length of the qubit control current line 5-2 along the Y-axis direction is slightly shorter than the interval between the source contact wiring S1 and the drain contact wiring D1.

In the second layer of the quantum dot structure portion 3-2, a power supply wiring 6-2B that stands toward the upper layer side is formed at an end portion of the qubit control current line 6-2 on the other side in the Y-axis direction. The power supply wiring 6-2B is formed in the same shape as the power supply wiring 6-2A. The lower end portion of the power supply wiring 6-2B is bent in the X-axis direction and is electrically connected to an end portion of the qubit control current line 6-2 on the other side in the Y-axis direction. The length of the qubit control current line 6-2 in the Y-axis direction is slightly shorter than the interval between the source contact wiring S1 and the drain contact wiring D1.

In the same lamination direction as in the above configuration, a source contact wiring S2 that stands upward is formed on the source electrode portion 8-nA side on one side in the Y-axis direction in the longitudinal direction of the n-th layer of the channel structure portion 8-n. A drain contact wiring Dn that stands upward is formed on a drain electrode portion 8-nB side on one side in the Y-axis direction in the longitudinal direction of the channel structure portion 8-2. The source contact wiring Sn and the drain contact wiring Dn are formed in a symmetrical structure and may be interchanged.

In the n-th layer of the quantum dot structure portion 3-n, a power supply wiring 5-nA that stands toward the upper layer side is formed at an end portion of the qubit control current line 5-n on one side in the Y-axis direction. The lower end portion of the power supply wiring 5-nA is bent in the X-axis direction and is electrically connected to an end portion of the qubit control current line 5-n on one side in the Y-axis direction. The length of the qubit control current line 5-n along the Y-axis direction is slightly shorter than the interval between the source contact wiring Sn and the drain contact wiring Dn.

In the n-th layer of the quantum dot structure portion 3-n, a power supply wiring 6-nB that stands toward the upper layer side is formed at an end portion of the qubit control current line 6-n on the other side in the Y-axis direction. The power supply wiring 6-nB is formed in the same shape as the power supply wiring 6-nA. The lower end portion of the power supply wiring 6-nB is bent in the X-axis direction and is electrically connected to an end portion of the qubit control current line 6-n on the other side in the Y-axis direction. The length of the qubit control current line 6-n along the Y-axis direction is slightly shorter than the interval between the source contact wiring Sn and the drain contact wiring Dn.

With the above configuration, in the semiconductor quantum device 1C, each power supply wiring connected to the qubit control current lines 5-n and 6-n adjacent to the quantum dot 4-n serving as a qubit is installed in a space separate from the source and the drain. The power supply wiring 5-nA connected to the qubit control current line 5-n and the power supply wiring 6-nA connected to the qubit control current line 6-n are disposed adjacent to the source contact wiring Sn in the X-axis direction. The power supply wiring 5-nB connected to the qubit control current line 5-n and the power supply wiring 6-nB connected to the qubit control current line 6-n are disposed adjacent to the drain contact wiring Dn in the X-axis direction.

[Fifth embodiment]

Hereinafter, a semiconductor quantum device 1D according to a fifth embodiment will be described. In the following description, the same configurations as in the first embodiment have the same names and reference numerals, and redundant description thereof will be appropriately omitted. The semiconductor quantum device 1D of the fifth embodiment is configured in the same manner as the semiconductor quantum device 1 of the first embodiment, except for the description below. Therefore, according to the semiconductor quantum device 1D of the fifth embodiment, the same effects as in the above-described semiconductor quantum device 1 of the first embodiment can be obtained except for the description below.

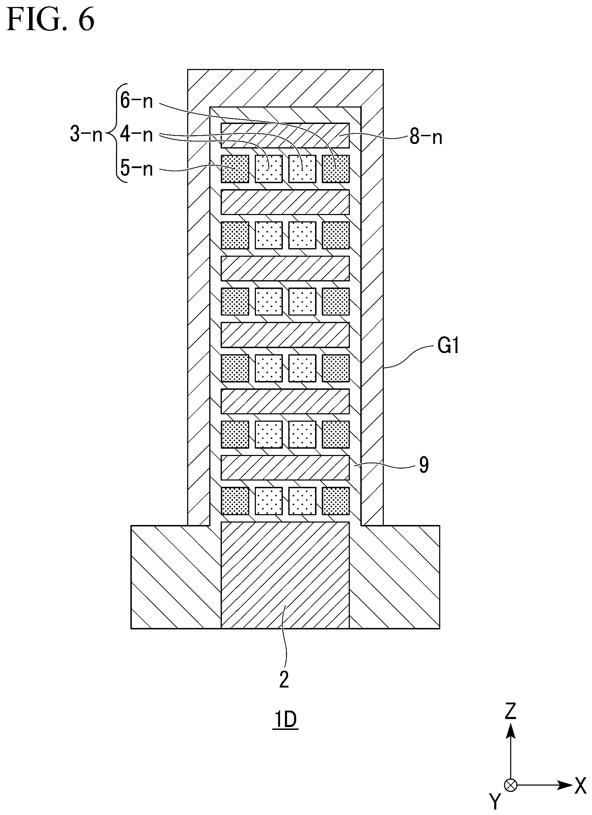

FIG. 6 shows a semiconductor quantum device 1D according to the fifth embodiment. In the semiconductor quantum device 1D, a plurality of quantum dots 4-n serving as qubits are disposed on a channel between a source and a drain in each quantum dot structure portion 3-n laminated in a lamination direction.

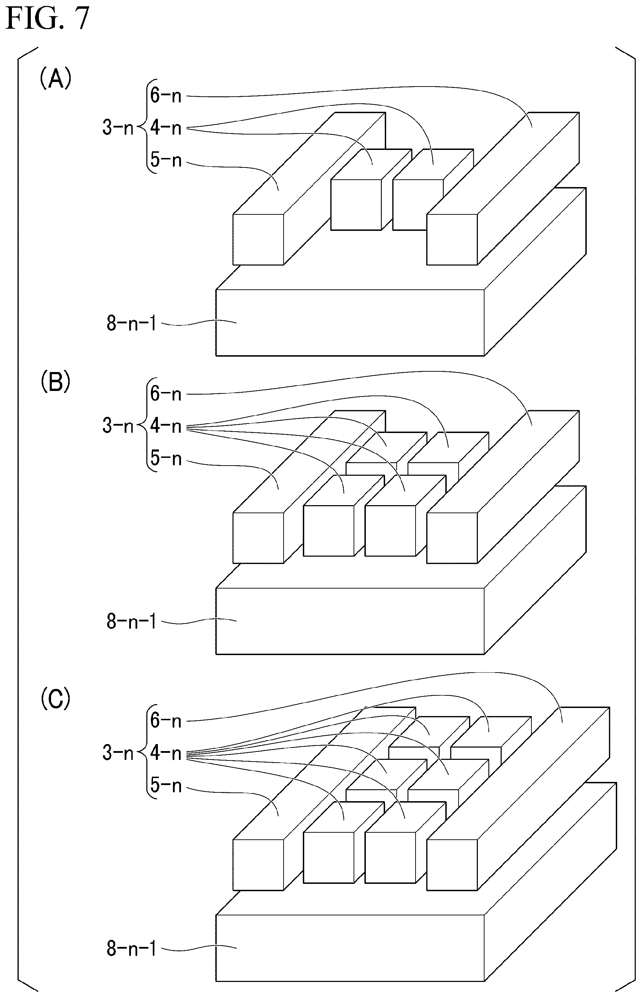

As shown in FIG. 7, a plurality of quantum dots 4-n are disposed in a lattice shape in each quantum dot structure portion 3-n. In actual film formation, the plurality of quantum dots 4-n in each of the quantum dot structure portions 3-n may be disposed separately. According to the semiconductor quantum device 1D, particularly in a case of using the gradient magnetic field of the magnetic body M as in the semiconductor quantum device 1A (refer to FIG. 3) according to the second embodiment, it is possible to apply separate magnetic fields to each of the quantum dots 4-n laminated in the lamination direction.

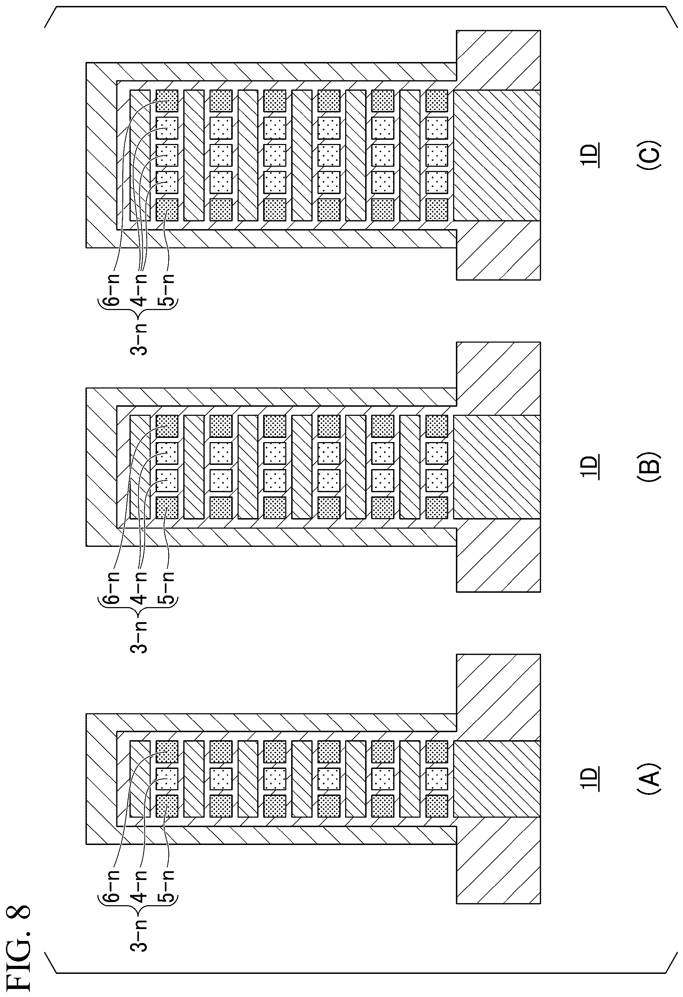

FIG. 8 shows a diagram in which the quantum dots 4-n disposed in FIG. 7 are disposed between the nanosheets (channel structure portions 8-n) laminated in the lamination direction. Here, a case where the same number of quantum dots 4-n are disposed between all the nanosheets is illustrated, but a different number of quantum dots 4-n may be disposed for each layer.

[Sixth embodiment]

Hereinafter, a semiconductor quantum device according to a sixth embodiment will be described. In the following description, the same configurations as in the first embodiment have the same names and reference numerals, and redundant description thereof will be appropriately omitted. The semiconductor quantum device of the sixth embodiment is configured in the same manner as the semiconductor quantum device 1 of the first embodiment, except for the description below. Therefore, according to the semiconductor quantum device of the sixth embodiment, the same effects as in the above-described semiconductor quantum device 1 of the first embodiment can be obtained except for the description below.

The logical qubit is usually formed of several charge spins. As a typical logical qubit, two charge spins are used. In a case where the external magnetic field is weak, the ground state of the two charge spins is a singlet state |S>, and a state that is strong against noise or the like is formed. The excited states of the two qubits are three triplet states (|T0>, |T+>, and |T->), and the mutual energy levels are changed by an applied magnetic field. The state is represented by Equation (1).
[Equation 1]

$$|T_+\rangle = |\uparrow\uparrow\rangle$$
$$|T_-\rangle = |\downarrow\downarrow\rangle$$
$$|T_0\rangle = (|\uparrow\downarrow\rangle + |\uparrow\downarrow\rangle)/\sqrt{2}$$
$$|S\rangle = (|\uparrow\downarrow\rangle - |\uparrow\downarrow\rangle)/\sqrt{2} \qquad \cdots (1)$$

Here, the external magnetic field is denoted by Bz as being applied in the z-axis direction of the spin quantization axis. In a case where the Hamiltonian of a transverse magnetic field part is denoted by $h_x{}^a = g\mu_B B_x{}^a$, $h_x{}^b = g\mu_B B_x{}^b$ while $B_x{}^a$, $B_x{}^b$ are transverse magnetic fields applied to two qubits a and b, the effect of the transverse magnetic field is represented by the following Equation (2).

[Equation 2]

$$H' = h_a^x(t)S_a^x \otimes I_b + h_b^x(t)I_a \otimes S_b^x$$

$$= \begin{array}{c} \\ |\uparrow\uparrow\rangle \\ |\uparrow\downarrow\rangle \\ |\downarrow\uparrow\rangle \\ |\downarrow\downarrow\rangle \end{array} \begin{pmatrix} \overset{|\uparrow\uparrow\rangle}{0} & \overset{|\uparrow\downarrow\rangle}{h_x^b} & \overset{|\downarrow\uparrow\rangle}{h_x^a} & \overset{|\downarrow\downarrow\rangle}{0} \\ h_x^b & 0 & 0 & h_x^a \\ h_x^a & 0 & 0 & h_x^b \\ 0 & h_x^a & h_x^b & 0 \end{pmatrix}$$

$$= \begin{array}{c} \\ |T_+\rangle \\ |T_-\rangle \\ |T_0\rangle \\ |S\rangle \end{array} \begin{pmatrix} \overset{|T+\rangle}{0} & \overset{|T_-\rangle}{0} & \overset{|T_0\rangle}{h_x^a + h_x^b} & \overset{|S\rangle}{-h_x^a + h_x^b} \\ 0 & 0 & h_x^a + h_x^b & h_x^a - h_x^b \\ h_x^a + h_x^b & h_x^a + h_x^b & 0 & 0 \\ -h_x^a + h_x^b & h_x^a - h_x^b & 0 & 0 \end{pmatrix} \quad \cdots (2)$$

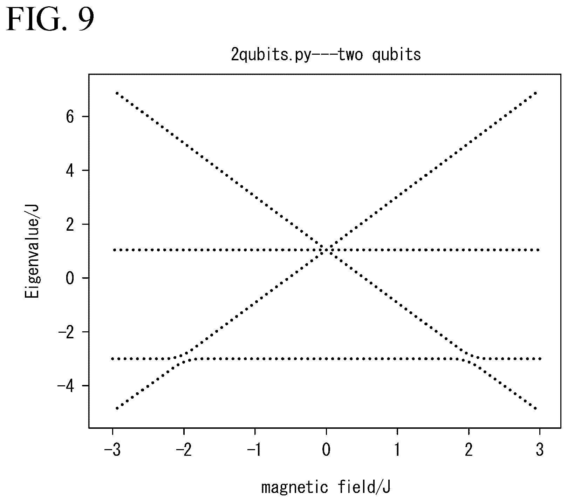

FIG. 9 shows energy levels of two qubits as a function of the external magnetic field. From the Equation, it can be seen that |S> and |T0> can be tunneled by the transverse magnetic field. FIG. 9 shows the eigen energy state of the two qubits as a function of the external magnetic field Bz. In a case where the external magnetic field is zero, the singlet state is the ground state, and in a case where the external magnetic field is strengthened, one of the singlet state and the triplet state intersects. In a case where these two states are $|0>_L$ and $|1>_L$ of the qubits, these two states tunnel each other in proportion to the magnitude of the transverse magnetic field, and thus $|0>_L$ and $|1>_L$ can be used as two energy levels of the qubits. As the transverse magnetic field increases, the coupling of the two levels becomes stronger, and as a result, the tunneling speed increases.

Since there is a variation in the individual qubits, the actual value of the external magnetic field is set to be close to the average value. The displacement of $|0>_L$ and $|1>_L$ at the intersection is determined by a difference in magnetic field or potential generated by an electrode on the side of the qubit. As the magnitude of the transverse magnetic field increases, the transition probability between $|0>_L$ and $|1>_L$ increases. That is, in a case where there is no transverse magnetic field, the transition does not occur, and the logical qubit can maintain the original state unless the transverse magnetic field is applied even in a case where there is no variation. In a case of three or more, one of the corresponding Hamiltonian ground state and excited state is used as the logical quantum state |1> and |0>.

[Seventh embodiment]

Hereinafter, a semiconductor quantum device according to a seventh embodiment will be described. In the following description, the same configurations as in the first embodiment have the same names and reference numerals, and redundant description thereof will be appropriately omitted. The semiconductor quantum device of the seventh embodiment is configured in the same manner as the semiconductor quantum device 1 of the first embodiment, except for the description below. Therefore, according to the semiconductor quantum device of the seventh embodiment, the same effects as in the above-described semiconductor quantum device 1 of the first embodiment can be obtained except for the description below.

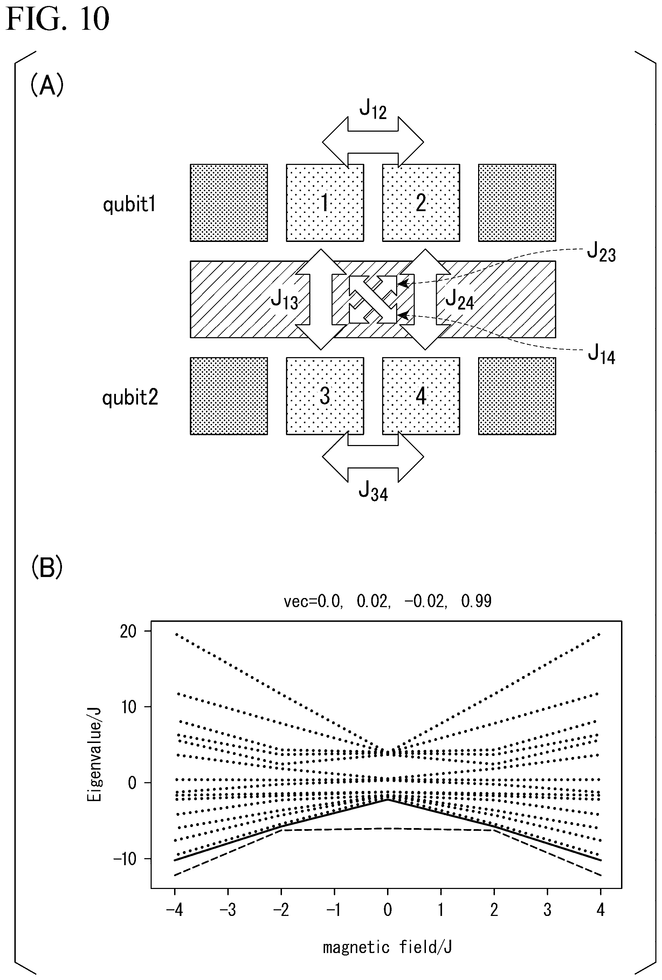

As the interaction between the logical qubits, for example, a Ruderman-Kittel-Kasuya-Yoshida (RKKY) interaction is used. As the operation between the two qubits, it is necessary to realize a CNOT gate operation. Four types of RKKY interactions are present in principle as shown in FIG. 10A. In FIG. 10A, the strength of the interaction between the qubits 1 to 4 is denoted by Jij (i, j = 1, ..., 4). This interaction is of a Heisenberg type and has a complicated shape, and thus it is extremely complicated to consider an operation while keeping the Heisenberg interaction without change.

FIG. 10B shows the eigen states thereof. In the present invention, by using the fact that the energy eigen states of the ground state and the excited state change depending on the states of two adjacent qubits, the operation of the logical qubits is performed as $|0>_L$ and $|1>_L$. That is, in a case where a voltage corresponding to an energy difference between $|0>_L$ and $|1>_L$ of a target logical bit is applied in a case where an adjacent logical qubit is |1>, the transition is performed between the energy states. This corresponds to the CNOT operation.

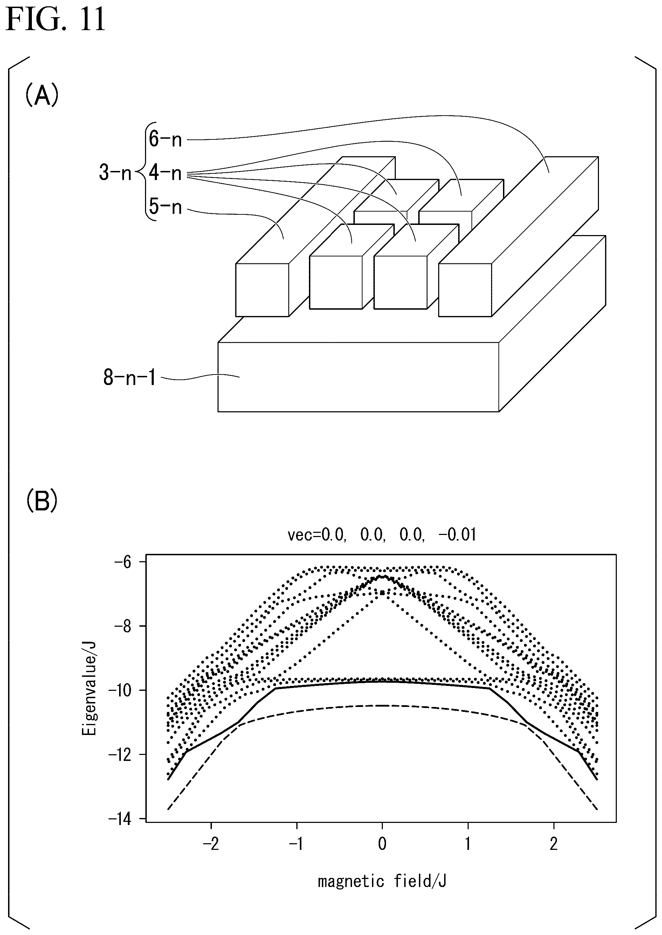

FIG. 11 shows an example in which the logical qubit is composed of four quantum dots 4-n. FIG. 11A shows an example of a case where four qubits are connected in pairs with the adjacent electric field and magnetic field control lines. The disposition of the four quantum dots 4-n is not limited to the shown example. FIG. 11B shows corresponding eigen states.

[Eighth embodiment]

Hereinafter, a semiconductor quantum device according to an eighth embodiment will be described. In the following description, the same configurations as in the first embodiment have the same names and reference numerals, and redundant description thereof will be appropriately omitted. The semiconductor quantum device of the eighth embodiment is configured in the same manner as the semiconductor quantum device 1 of the first embodiment, except for the description below. Therefore, according to the semiconductor quantum device of the eighth embodiment, the same effects as in the above-described semiconductor quantum device 1 of the first embodiment can be obtained except for the description below.

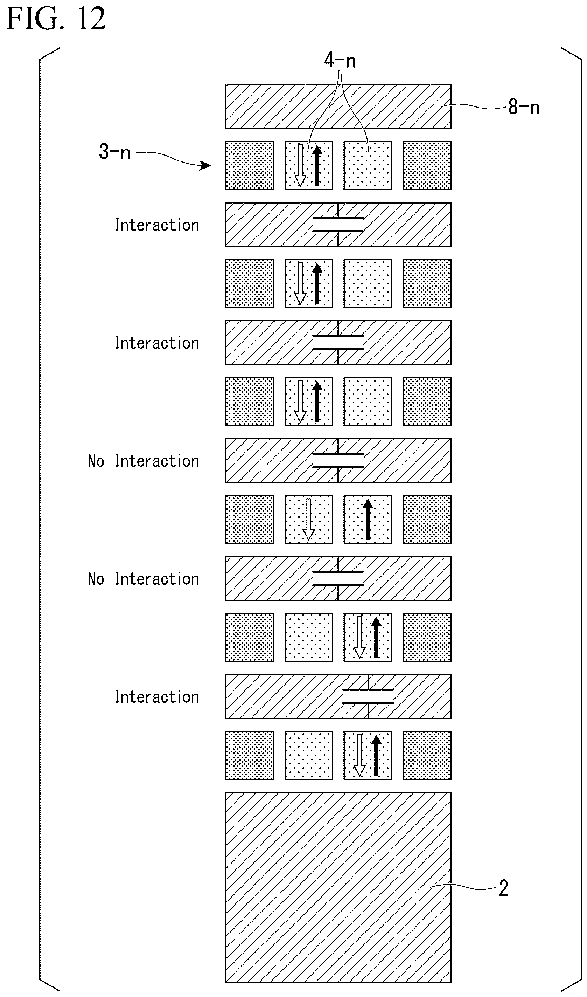

FIG. 12 shows a method of performing a quantum operation by changing the strength of the electrostatic coupling between the nanosheets. As a principle, in the logical qubit structure, the method of Taylor et al. of Non-Patent Document 6 is used. In this case, the logical qubits need to be coupled by a Coulomb force. In this case, in a case where the potential of the electric field control and magnetic field generation lines on one side is lowered, the depletion layer on the lowered side expands, and thus the charge coupling between the layers is non-uniform between the left and right qubits. This situation realizes the control of the coupled quantum dots of Taylor et al.

In the present invention, by setting the potentials of the interface of the channel portion to different values in the two quantum dots in the horizontal direction, the thickness of the depletion layer in the channel varies between the qubits, and as a result, the electrostatic capacity can be reduced between the upper and lower quantum dots 4-n sandwiched between the same channel. That is, in a place where the depletion layer is large, the capacitance coupling between the top and bottom of the channel, that is, between the quantum dots 4-n laminated in the lamination direction is weakened, and the upper and lower quantum dots 4-n become independent. As a result, the upper and lower qubits of Taylor et al. can be coupled. The RKKY interaction is effective in a case where a free charge is present in the channel, and thus the RKKY interaction can be turned off in a case where the individual quantum dots 4-n are manipulated.

[Ninth embodiment]

Hereinafter, a semiconductor quantum device according to a ninth embodiment will be described. In the following description, the same configurations as in the first embodiment have the same names and reference numerals, and redundant description thereof will be appropriately omitted. The semiconductor quantum device of the second embodiment is configured in the same manner as the semiconductor quantum device 1 of the first embodiment, except for the description below. Therefore, according to the semiconductor quantum device of the ninth embodiment, the same effects as in the above-described semiconductor quantum device 1 of the first embodiment can be obtained except for the description below.

In a case of focusing on a singlet state $|S\rangle$ and a triplet state $|T_0\rangle$, the Hamiltonian can be separated from $|T+\rangle$, $|T-\rangle$ in a range in which the variation can be negligible as in Equation (3).

[Equation 3]

$$
H_{22}^{\text{new}} = \begin{pmatrix} E_{T_a} + E_{T_b} & 0 & 0 & 0 \\ 0 & E_{T_a} + E_{S_b} & 0 & 0 \\ 0 & 0 & E_{S_a} + E_{T_b} & 0 \\ 0 & 0 & 0 & E_{S_a} + E_{S_b} \end{pmatrix}
$$

$$
+ \begin{pmatrix} 2J_p b & 0 & 0 & J_p r + J_s(1-b) \\ 0 & 0 & J_s & 0 \\ 0 & J_s & 0 & 0 \\ J_p r + J_s(1-b) & 0 & 0 & -2J_s r \end{pmatrix} \quad \cdots (3)
$$

In this range, the Hamiltonian can also be used for quantum computation. The conversion of $|S\rangle$ to $|T_0\rangle$ is realized by setting the quantization axis of the magnetic field generation line as the z-axis and reversing the directions of the left and right magnetic fields.

[Tenth embodiment]

Hereinafter, a semiconductor quantum device 1E according to a tenth embodiment will be described. In the following description, the same configurations as in the first embodiment have the same names and reference numerals, and redundant description thereof will be appropriately omitted. The semiconductor quantum device 1E of the tenth embodiment is configured in the same manner as the semiconductor quantum device 1 of the first embodiment, except for the description below. Therefore, according to the semiconductor quantum device 1E of the tenth embodiment, the same effects as in the above-described semiconductor quantum device 1 of the first embodiment can be obtained except for the description below.

Quantum error correction code is required for the quantum operation. Non-Patent Document 7 specifies a representative surface code or a topological surface code. Hereinafter, referred to as a surface code. The surface codes need to perform CNOT gates in order in four directions of the top, bottom, left and right in the drawing. The CNOT gate converts a bit of the target qubit between |0> and |1> in a case where the control qubit is |1>. That is, the conversion of |10> ⇔ |11> is performed. The eigen energies corresponding to the four states |00>, |01>, |10>, and |11> need to be different from each other. In order to create this situation, two energy levels for performing the CNOT gate are changed. In order to efficiently control the individual qubits, the qubits may have different Zeeman energies. In this situation, in a case where the Zeeman energies are set by the external magnetic field, the variation in the g factor realizes this situation. In a case of placing the magnetic body, the distance from the magnetic body to the qubit is different for each qubit, so that this situation can be realized.

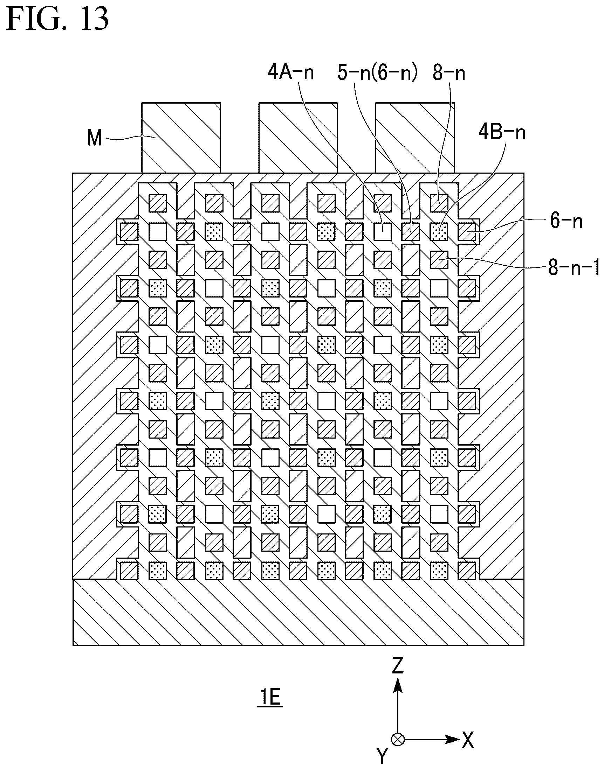

FIG. 13 shows a semiconductor quantum device 1E to which the present invention is applied and which is configured with a layout in which surface codes can be implemented. In this example, the channel structure portion 8-n also serves as a measurement channel for measuring the spin state using the electric field control and magnetic field generation lines. The channel structure portion 8-n is configured to jointly use the qubit control current lines 5-n and 6-n and a measurement channel for measuring the spin state of the quantum dot 4-n. That is, the channel structure portion 8-n of FIG. 1, FIG. 3, and the like also serves as a measurement channel with the current magnetic field control lines (qubit control current lines 5-n and 6-n). The semiconductor quantum device 1E includes a plurality of data qubits 4A-n, a plurality of measurement qubits 4B-n, and a plurality of wirings (a pair of channel structure portions 8-n and 8-n-1, and a pair of qubit control current lines 5-n and 6-n) on a substrate (not shown).

The semiconductor quantum device 1E includes a plurality of quantum dot structure portions with a plurality of data qubits 4A-n and a plurality of measurement qubits 4B-n that are disposed on the substrate in a lamination direction and a layer direction orthogonal to the lamination direction. The semiconductor quantum device 1E includes a plurality of qubit control current lines with a plurality of wirings (a pair of channel structure portions 8-n and 8-n-1 and a pair of qubit control current lines 5-n and 6-n) that are disposed between the quantum dot structure portions adjacent in the lamination direction and the layer direction on the substrate. The semiconductor quantum device 1E includes a magnetic body M that applies a magnetic field to a plurality of quantum dot structure portions.

The data qubit 4A-n is composed of quantum dots. The plurality of data qubits 4A-n are disposed in a matrix along a vertical direction (also referred to as a Z-axis direction or a lamination direction) and a horizontal direction (also referred to as an X-axis direction or a layer direction) orthogonal to the vertical direction. The measurement qubit 4B-n is composed of quantum dots. The plurality of measurement qubits 4B-n are disposed in a matrix along the Z-axis direction and the X-axis direction. The data qubits 4A-n and the measurement qubits 4B-n are alternately arranged in the vertical direction and the horizontal direction. A plurality of wirings (a pair of channel structure portions 8-n and 8-n-1, and a pair of qubit control current lines 5-n and 6-n) serving as electric field control and magnetic field generation lines are disposed in the periphery of the data qubit 4A-n and the measurement qubit 4B-n in a vertical direction and a horizontal direction.

This is because two types of CNOT gate operations in the horizontal direction and the vertical direction are required in the implementing of the surface codes. Therefore, in a case of the CNOT gate operation in the vertical direction, the CNOT gate is performed only in the vertical direction (Z-axis direction) by controlling the pair of qubit control current lines 5-n and 6-n using the method shown in the previous examples. In the horizontal direction (X-axis direction), the CNOT gate is performed only in the horizontal direction (X-axis direction) by controlling the pair of channel structure portions 8-n and 8-n-1 serving as the electric field control and magnetic field generation lines. In a case of using the magnetic body M such as a nanomagnet, a high-frequency electric field is generated to apply an effective change in the magnetic field and generate a magnetic field based on a current.

In a case where the CNOT gate operation is required in the horizontal direction, the CNOT gate operation using the in-wiring charge is performed between the two pairs of qubit control current lines 5-n and 6-n in the horizontal direction, and in the vertical direction, magnetic field gradient is generated or a magnetic field is generated in the pair of channel structure portions 8-n and 8-n-1, which serve as two electric field control and magnetic field generation lines that sandwich a vertical qubit. In this case, since each wiring (the pair of channel structure portions 8-n and 8-n-1 and the pair of qubit control current lines 5-n and 6-n) also serves as a channel, it is necessary to configure the wiring with a semiconductor. In particular, a nanowire structure or the like in a material of silicon or a material obtained by synthesizing silicon with another substance is appropriate.

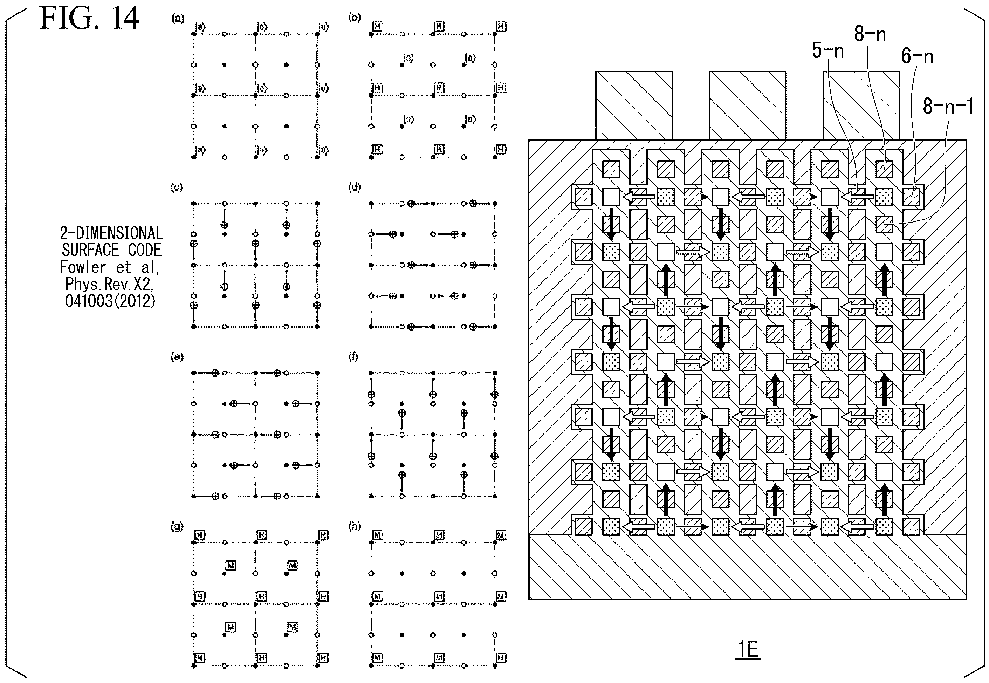

FIG. 14 shows an example in which a quantum operation is performed in order using the semiconductor quantum device 1E. With this configuration, two types of CNOT gate operations are performed on the plurality of quantum dot structure portions in the lamination direction and the layer direction based on the magnetic field generated by the wirings (the pair of channel structure portions 8-n and 8-n-1 and the pair of qubit control current lines 5-n and 6-n) constituting the qubit control current lines. As a result, the surface code for performing quantum error correction is given to the plurality of quantum dot structure portions each of which is composed of the plurality of data qubits 4A-n and the plurality of measurement qubits 4B-n.

FIG. 14 is an example of a procedure for executing the surface code. (a) of FIG. 14 shows a process of setting the measurement qubits into an initial state. (b) of FIG. 14 shows a process of applying a Hadamard gate to the measurement qubits. (c) and (f) of FIG. 14 show a process in which the CNOT gate operation is performed in the vertical direction. (d) and (e) of FIG. 14 show a process in which the CNOT gate operation is performed in the horizontal direction. In a case where the channel structure portion measures a state of the qubits in a horizontal direction, the upper and lower channel structure portions 8-n and 8-n-1 that sandwich the qubits become the current control lines. In the next surface code process, the upper and lower channel structure portions 8-n and 8-n-1 of the qubits play a role of the channel structure portion that measures the state of the qubits, and the qubit control current lines 5-n and 6-n in the horizontal direction become the current magnetic field control lines.

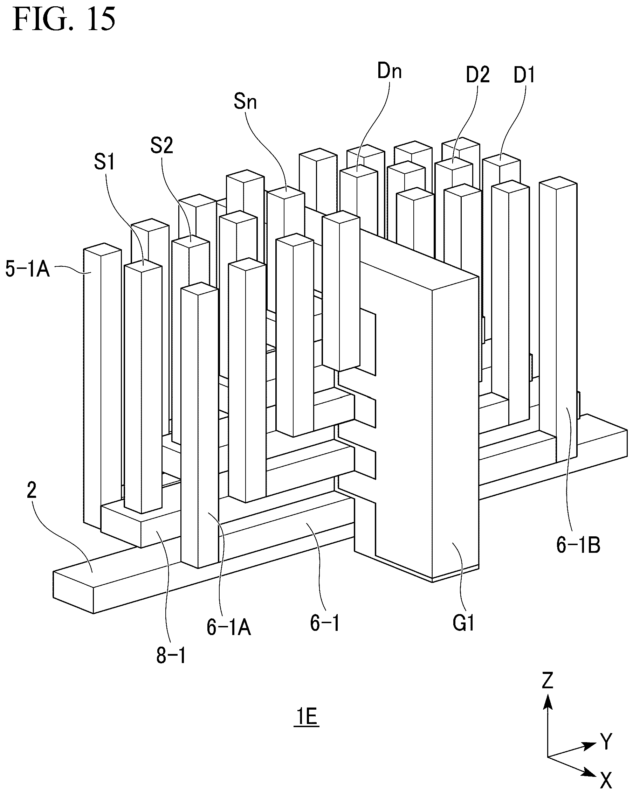

FIG. 15 shows a structure of a semiconductor quantum device 1E corresponding to FIGS. 3 to 5. In the semiconductor quantum device 1E, the power supply wirings 5-nA, 5-nB, 6-nA, and 6-nB to the qubit control current lines are configured slightly differently from those in FIGS. 3 to 5.

FIG. 15 shows a perspective view showing a configuration of the semiconductor quantum device 1E according to the tenth embodiment. In the drawing, reference numerals 8-n, 5-n, and 6-n are written, but depending on the stage of the surface code, they also serve as the qubit control current line and a channel structure portion that reads out the state of the qubit. Unlike FIG. 4, the relative positions of 5-n, 6-n, and 8-n of the contact wirings may change. This structure can also be applied to a general quantum error correction code. The quantum error correction code may include a topological code other than the surface code, a stabilizer code, a low-density parity check code, or a code that takes a majority vote, such as Shor's code.

[Eleventh embodiment]

Hereinafter, a semiconductor quantum device 1F according to an eleventh embodiment will be described. In the following description, the same configurations as in the first embodiment have the same names and reference numerals, and redundant description thereof will be appropriately omitted. The semiconductor quantum device 1F of the eleventh embodiment is configured in the same manner as the semiconductor quantum device 1 of the first embodiment, except for the description below. Therefore, according to the semiconductor quantum device 1F of the eleventh embodiment, the same effects as in the above-described semiconductor quantum device 1 of the first embodiment can be obtained except for the description below.

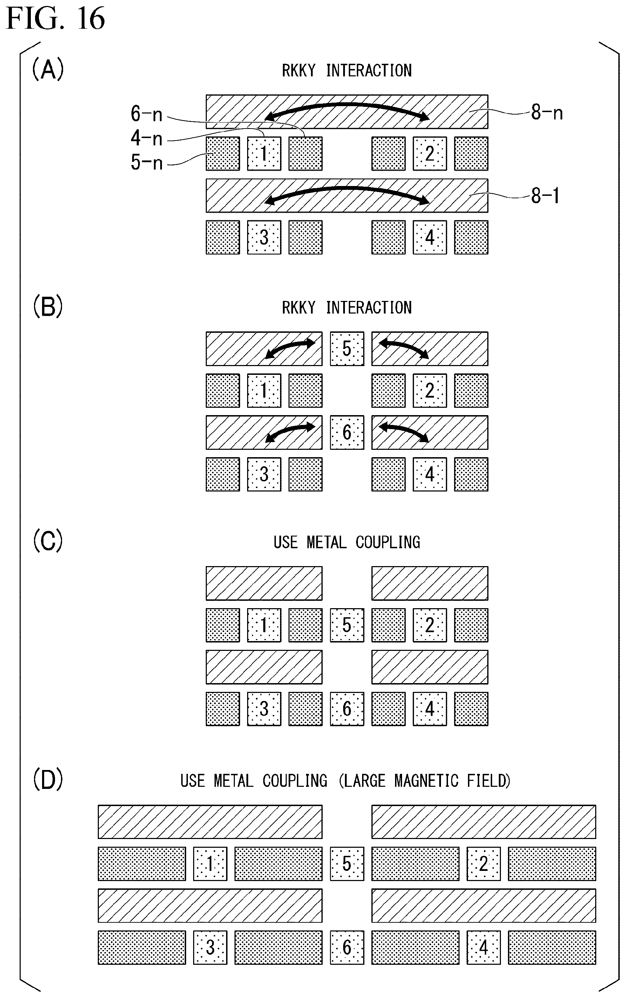

FIG. 16 shows the shapes of the interaction of the RKKY interaction in the horizontal direction in FIG. 1 or FIG. 2. Various couplings can be realized depending on the position of the quantum dot interposed therebetween.

[Twelfth embodiment]

Hereinafter, semiconductor quantum devices 1G and 1H according to a twelfth embodiment will be described. In the following description, the same configurations as in the first embodiment have the same names and reference numerals, and redundant description thereof will be appropriately omitted. The semiconductor quantum devices 1G and 1H of the twelfth embodiment are configured in the same manner as the semiconductor quantum device 1 of the first embodiment, except for the description below. Therefore, according to the semiconductor quantum devices 1G and 1H of the twelfth embodiment, the same effects as in the above-described semiconductor quantum device 1 of the first embodiment can be obtained except for the description below.

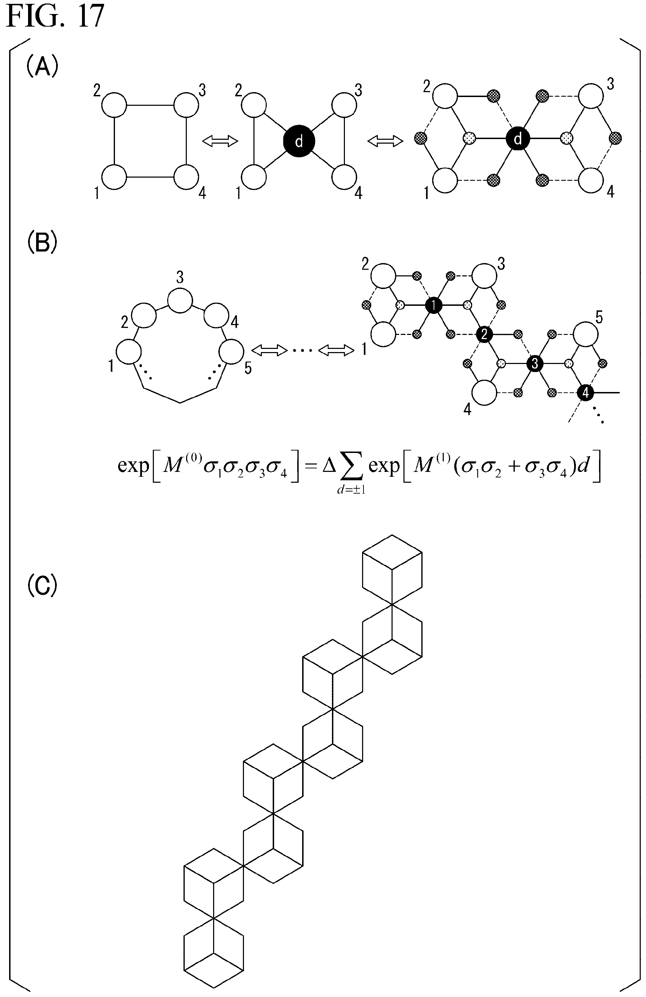

Regarding the configuration in a case of implementing quantum annealing, with the structure of the above-described example, in the same manner as in Patent Document 1, the plurality of qubits can be coupled to each other by a method of copying the same data to the plurality of qubits. In the present embodiment, as another method, an invention for a method of realizing the method of Non-Patent Document 8 will be described. As shown in (a) of FIG. 17, this is a method of coupling spins to each other by forming a coupling structure that adds the upper and lower spins corresponding to "d" in the drawing. The mathematical principle is based on the following Equation (4), and uses the identity in which the interaction of the four bodies on the left side can be composed of the interaction of the two bodies on the right side.

[Equation 4]

$$\exp\left[ M^{(0)}\sigma_1\sigma_2\sigma_3\sigma_4 \right] = \Delta \sum_{d=\pm 1} \exp\left[ M^{(1)}(\sigma_1\sigma_2 + \sigma_3\sigma_4)d \right] \quad \cdots (4)$$

Here, $M^{(0)}$ and $M^{(1)}$ are appropriate proportionality coefficients. In order to realize the Equation, as shown in FIG. 17, a coupling structure that couples spins generated in vertically disposed qubits is created based on the disposition of the qubits, and then two manipulations of a case in which the spin of "d" is $|\uparrow>$ and a case in which the spin of "d" is $|\downarrow>$ by the gate manipulation are performed to add up and down the spins. By developing Equation (4), it is possible to create a coupling $\sigma_1\sigma_2...\sigma_N$ of any number (N) of spins as shown in (b) of FIG. 17. On the substrate, the qubits (spins) that are spatially separated from each other first create the coupling, and then the intermediate qubits may be measured. For example, the coupling $\sigma_1\sigma_N$ of the first and N-th qubits can be formed by first generating the coupling $\sigma_2...\sigma_{N-1}$ and then measuring the intermediate coupling $\sigma_1\sigma_2...\sigma_N$. The state on the right side can be realized by forming a Cat State in general.

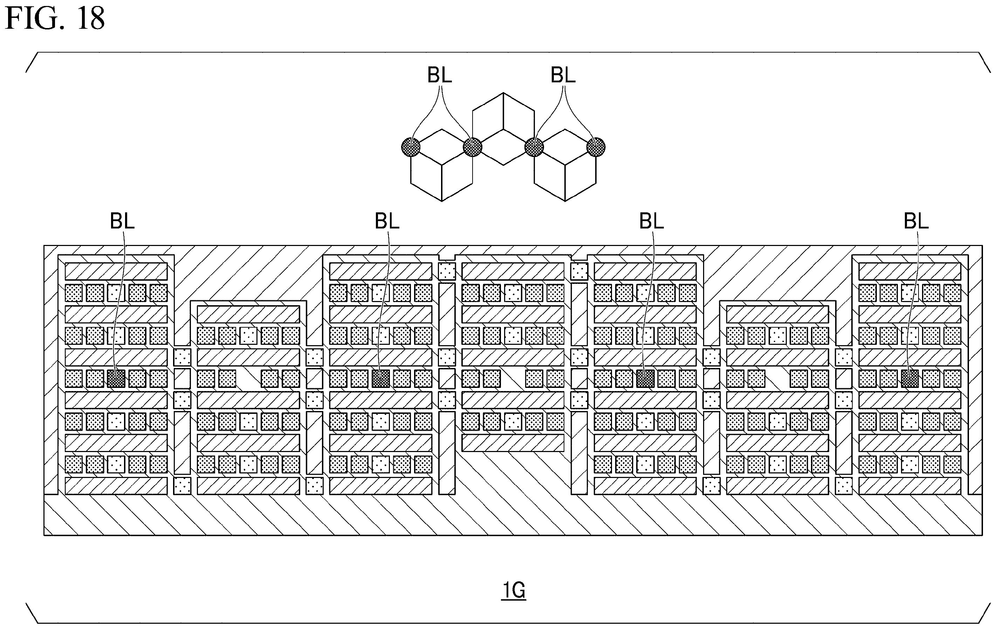

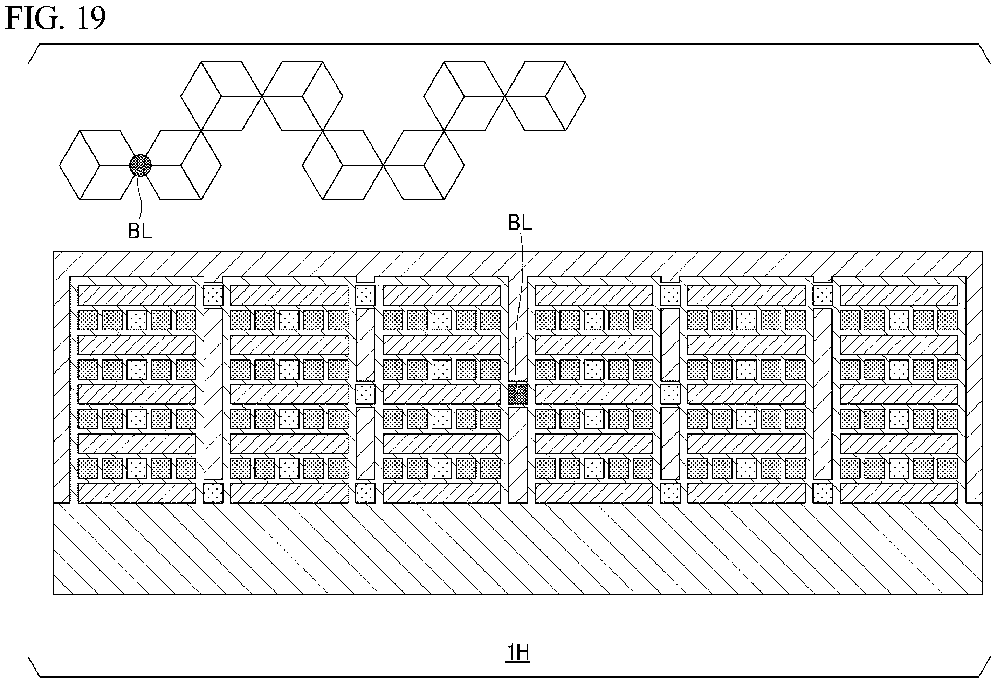

The semiconductor quantum device 1G shown in FIG. 18 and the semiconductor quantum device 1H shown in FIG. 19 show a method of realizing the state. First, in FIGS. 18 and 19, the interaction term that is coupled to six qubits uses the RKKY interaction. For the other qubits, by forming a coupling structure that adds the left and right spins, the qubits can be formed by coupling in the vertical direction. That is, the plurality of quantum dot structure portions disposed on the substrate 2 in the lamination direction and the layer direction include a coupling structure that couples spins generated in the qubits of the quantum dot structure portions adjacent to each other in the lamination direction or the layer direction. The coupling structure couples any number of qubits for quantum annealing. In FIG. 18 and FIG. 19, the bottom diagrams show cases where the coupling structures shown in the top diagrams are realized. Each black point BL is a qubit of a coupling point and corresponds to a qubit of the black point BL in each bottom diagram.

[Thirteenth embodiment]

Hereinafter, a semiconductor quantum device according to a thirteenth embodiment will be described. In the following description, the same configurations as in the first embodiment have the same names and reference numerals, and redundant description thereof will be appropriately omitted. The semiconductor quantum device of the thirteenth embodiment is configured in the same manner as the semiconductor quantum device 1 of the first embodiment, except for the description below. Therefore, according to the semiconductor quantum device of the thirteenth embodiment, the same effects as in the above-described semiconductor quantum device 1 of the first embodiment can be obtained except for the description below.

The qubit system according to the present invention can be used for quantum reservoir computing. In the quantum reservoir computing, a vocal cord signal is converted into an electrical signal to form a learning pulse sequence for input. In a case where the learning pulse sequence is input to the gate, an interaction occurs between the qubits according to the pulse sequence. In a case where the RKKY interaction between the qubits is turned on, the current flowing between the source and the drain changes non-linearly depending on the level of the voltage input to the gate. A region in which Random Telegraph Noise (RTN) is generated can also be used for the quantum reservoir computing. RTN is a non-linear phenomenon in which conduction electrons are temporarily trapped in defects present at a gate insulating film interface or the like. It can be considered that the memory effect is exhibited while the electrons are trapped. The weight in the quantum reservoir computing can be obtained based on the current value between the source and the drain with respect to the gate voltage.

The above can be realized even in a normal CMOS, but the state of the electron spin in the quantum dot strengthens the operation of the quantum reservoir computing as a memory effect. The electron spin in the quantum dot has a coherence time. Quantum reservoir computing with higher nonlinearity can also be realized by applying a magnetic field to align the spin states and adding a pulse in which the spins are inverted to the RTN pulse described above.

[Fourteenth embodiment]

Hereinafter, a semiconductor quantum device according to a fourteenth embodiment will be described. In the following description, the same configurations as in the first embodiment have the same names and reference numerals, and redundant description thereof will be appropriately omitted. The semiconductor quantum device of the fourteenth embodiment is configured in the same manner as the semiconductor quantum device 1 of the first embodiment, except for the description below. Therefore, according to the semiconductor quantum device of the fourteenth embodiment, the same effects as in the above-described semiconductor quantum device 1 of the first embodiment can be obtained except for the description below.

In order to determine the result of the operation of the qubits, for example, a method of using a latch circuit connected to the first quantum circuit and the second quantum circuit, which is an inversion circuit, latching the state of the first qubit output from the first quantum circuit, amplifying the signal indicating the state of the first qubit, latching the state of the second qubit output from the second quantum circuit, and amplifying the signal indicating the state of the second qubit is considered. The result of the qubit shown in the invention is output as a voltage change between the source and drain of the nanosheet. Since this output signal is smaller than a normal CMOS circuit, amplification is required. The latch circuit enables amplification in the first stage thereof. However, in an amplification circuit such as the latch circuit, the variation in the offset voltage of each amplification circuit may be often a problem. Therefore, by combining the interpolation method of Non-Patent Document 8, it is possible to read out even in consideration of the variation of the amplification circuit composed of the CMOS.

[Fifteenth embodiment]

Hereinafter, a semiconductor quantum device according to a fifteenth embodiment will be described. In the following description, the same configurations as in the first embodiment have the same names and reference numerals, and redundant description thereof will be appropriately omitted. The semiconductor quantum device of the fifteenth embodiment is configured in the same manner as the semiconductor quantum device 1 of the first embodiment, except for the description below. Therefore, according to the semiconductor quantum device of the fifteenth embodiment, the same effects as in the above-described semiconductor quantum device 1 of the first embodiment can be obtained except for the description below.

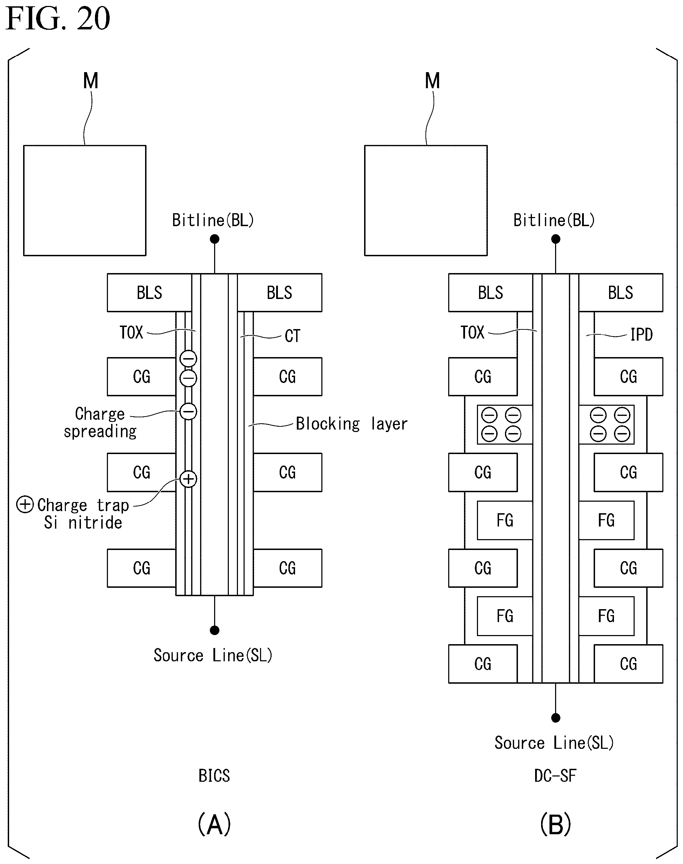

FIG. 20 shows an example in a case where a qubit operation is performed in a three-dimensional NAND flash. That is, in the semiconductor quantum device, the quantum dot structure portion may be formed of a three-dimensional NAND flash memory. A charge trap in (a) of FIG. 20 and a Floating Gate (FG) in (b) of FIG. 20 are parts where charge is stored, and these parts can be made into one or more logical spin qubits by applying a magnetic field to the outside. The spin state of the qubit is measured by a current flowing through the channel.

A source of a non-uniform magnetic field generated from a magnetic body is a Control Gate (CG). By generating a high-frequency potential difference between the CGs that sandwich the qubit to be controlled, the effect of a transverse magnetic field can be generated on the qubit. The interaction between the qubits is realized by the RKKY interaction or the like via a bitline in the diagram.

[Sixteenth embodiment]

Hereinafter, a semiconductor quantum device according to a sixteenth embodiment will be described. In the following description, the same configurations as in the first embodiment have the same names and reference numerals, and redundant description thereof will be appropriately omitted. The semiconductor quantum device of the sixteenth embodiment is configured in the same manner as the semiconductor quantum device 1 of the first embodiment, except for the description below. Therefore, according to the semiconductor quantum device of the sixteenth embodiment, the same effects as in the above-described semiconductor quantum device 1 of the first embodiment can be obtained except for the description below.

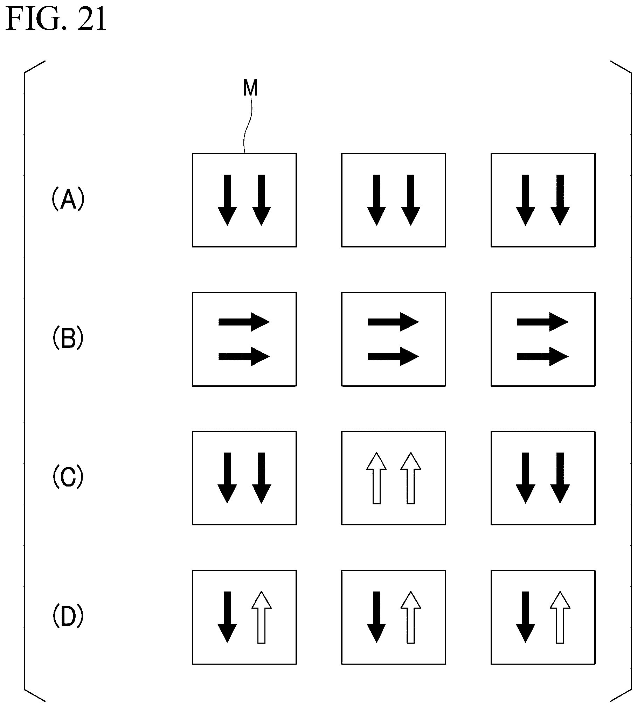

The semiconductor quantum device may be realized using electrons or holes. As the magnetic body M that generates a magnetic field, an alloy consisting of these materials is used in addition to cobalt, iron, nickel, and gadolinium. In addition, the directions of all the magnetic domains may be parallel to the magnetic bodies M as shown in (a) of FIG. 21, or may be horizontal or oblique with respect to the substrate as shown in (b) of FIG. 21. Further, as shown in (c) of FIG. 21, the directions of the axes may be different between the individual magnetic bodies M. In particular, in a case where the magnetic domains of the magnetic bodies M adjacent to each other are opposite to each other as shown in (c) of FIG. 21, the gradients of the magnetic fields generated by the magnetic bodies are increased, thereby being effective. In addition, as shown in (d) of FIG. 21, a plurality of magnetic domain structures may be provided in the same magnetic body.

In the examples, an example of using the magnetic fields in the quantized magnetic domain direction and the magnetic charge direction perpendicular to the quantized magnetic domain direction has been described, but the spin-orbit interaction between holes and conduction electrons in a quantum dot can also be used.

[Seventeenth embodiment]

Hereinafter, a semiconductor quantum device according to a seventeenth embodiment will be described. In the following description, the same configurations as in the first embodiment have the same names and reference numerals, and redundant description thereof will be appropriately omitted. The semiconductor quantum device of the seventeenth embodiment is configured in the same manner as the semiconductor quantum device 1 of the first embodiment described above, except for the description below. Therefore, according to the semiconductor quantum device of the seventeenth embodiment, the same effects as in the above-described semiconductor quantum device 1 of the first embodiment can be obtained except for the description below.

The quantum dots of the semiconductor quantum device may be composed of a semiconductor material such as silicon, silicon germanium (SiGe), germanium, gallium arsenide, or gallium nitride, or a metal such as Al, Co, or Fe. The size of the quantum dot is desirably equal to or less than 45 nm. A silicon oxide film, a tunneling film used for general silicon transistors such as TiN, SiN, and hafnium oxide, or a high-K material such as a high-K material can be used between the electric field and magnetic field control lines adjacent to the qubit. Between the qubit and the adjacent electric field and magnetic field control lines, a tunneling film used in general silicon transistors, such as a silicon oxide film, TiN, SiN, or a high-K material such as hafnium oxide, can be used. In addition, a distance between the qubit and the electric field and magnetic field control lines adjacent to the qubit is desirably equal to or less than 5 nm.

Hereinabove, the embodiments of the present invention have been described, but the present invention is not limited to the embodiments and can be appropriately modified without departing from the gist thereof.

REFERENCE SIGNS LIST

1, 1A-1H Semiconductor quantum device
2 Substrate
3,3-n Quantum dot structure portion
4A-n Data qubit
4B-n Measurement qubit
4-n Quantum dot
5-n, 6-n Qubit control current line
5-nA, 5-nB, 6-nA, 6-nB Power supply wiring
8, 8-n Channel structure portion
9 Insulating layer
D Drain
D1, Dn Drain contact wiring
G1 Gate
M Magnetic body
S Source
S1, Sn Source contact wiring
T Transistor structure portion

Claims

1. A semiconductor quantum device, comprising:

a transistor structure portion configured to have a source, a drain, and a gate;
one or more quantum dot structure portions configured to localize charges; and
a qubit control current line configured to change states of the charges in the quantum dot structure portions,
wherein the quantum dot structure portions and the qubit control current line are disposed in the same layer, and the transistor structure portion and the quantum dot structure portions are laminated in a lamination direction with respect to a substrate.

2. The semiconductor quantum device according to Claim 1,

wherein the transistor structure portion configured to have a plurality of channel structure portions that connect the source and the drain,
the plurality of channel structure portions are laminated in the lamination direction with respect to the substrate,
the quantum dot structure portion is provided between the channel structure portions adjacent in the lamination direction,
electrons or holes are accumulated in the quantum dot structure portion, and
the qubit control current line allows a qubit control current for controlling a magnetic field that controls spin states of the electrons or holes in the quantum dot structure portion to flow, and is disposed to be close to the quantum dot structure portion.

3. The semiconductor quantum device according to Claim 2,

wherein the transistor structure portion is a nanosheet-type transistor configured to have the plurality of channel structure portions sandwiching the quantum dot structure portion.

4. The semiconductor quantum device according to Claim 2,
wherein the magnetic field that controls the spin states of the electrons or holes in the quantum dot structure portion is one or more magnetic bodies installed close to the transistor structure portion.

5. The semiconductor quantum device according to Claim 2, further comprising:

at least a first quantum dot structure portion and a second quantum dot structure portion configured as the quantum dot structure portion,
wherein the plurality of channel structure portions include a first channel structure portion disposed between the first quantum dot structure portion and the second quantum dot structure portion, and
a quantum state of a charge spin in the first quantum dot structure portion is changed by using a magnetic field generated by flowing the qubit control current through the qubit control current line, and an interaction between the charge spin in the first quantum dot structure portion and a charge spin in the second quantum dot structure portion is set as an indirect interaction via the charge in the first channel structure portion.

6. The semiconductor quantum device according to Claim 5,

wherein the semiconductor quantum device has a manipulation mode, and
in the manipulation mode, a current of the qubit control current line is set to a value that is not zero, a voltage of the gate is set to a value that is greater than zero, a voltage of the source is set to a value that is not zero, a voltage of the drain is set to a value that is not zero, a magnetic field generated by at least the qubit control current line is set to a value that is not zero, and a Ruderman-Kittel-Kasuya-Yosida (RKKY) interaction is used.

7. The semiconductor quantum device according to Claim 1,

wherein a plurality of the quantum dot structure portions are disposed on the substrate in the lamination direction and a layer direction orthogonal to the lamination direction,
a plurality of the qubit control current lines are disposed between the quantum dot structure portions adjacent in the lamination direction and the layer direction, and
by controlling the qubit control current lines in a state where a magnetic field is applied to a plurality of the quantum dot structure portions, two types of CNOT gate operations are performed on the plurality of quantum dot structure portions in the lamination direction and the layer direction, and a quantum error correction code for performing quantum error correction is given to the plurality of quantum dot structure portions.

8. The semiconductor quantum device according to Claim 2,
wherein the channel structure portion is configured to jointly use the qubit control current line and a measurement channel for measuring a spin state of the quantum dot structure portion.

9. The semiconductor quantum device according to Claim 1, further comprising:

a plurality of the quantum dot structure portions disposed on the substrate in the lamination direction and a layer direction orthogonal to the lamination direction,
wherein a plurality of the quantum dot structure portions have a coupling structure that couples spins generated in the qubits of the quantum dot structure portions adjacent in the lamination direction or the layer direction, and
the coupling structure couples any number of qubits for quantum annealing.

10. The semiconductor quantum device according to Claim 1,
wherein the quantum dot structure portion is formed of a three-dimensional NAND flash memory.

FIG. 1

# FIG. 2

(A)

6−n
3−n { 4−n
5−n

2,8−n

(B)

6−n
3−n { 4−n
5−n

2,8−n

# FIG. 3

1A

FIG. 4

FIG. 5

1C

FIG. 6

1D

## FIG. 7

(A)

6-n
3-n { 4-n
5-n
8-n-1

(B)

6-n
3-n { 4-n
5-n
8-n-1

(C)

6-n
3-n { 4-n
5-n
8-n-1

FIG. 8

(A)

1D

(B)

1D

(C)

1D

EP 4 589 663 A1

# FIG. 9

2qubits.py---two qubits

## FIG. 10

(A)

(B)

vec=0.0, 0.02, −0.02, 0.99

## FIG. 11

(A)

(B)

## FIG. 12

4-n

8-n

3-n

Interaction

Interaction

No Interaction

No Interaction

Interaction

2

FIG. 13

FIG. 14

(a) (b) (c) (d) (e) (f) (g) (h)

2-DIMENSIONAL
SURFACE CODE
Fowler et al,
Phys.Rev.X2,
041003(2012)

5-n 8-n 6-n 8-n-1

1E

EP 4 589 663 A1

FIG. 15

1E

## FIG. 16

(A)

RKKY INTERACTION

6-n
4-n
5-n

8-n

1    2

8-1

3    4

(B)

RKKY INTERACTION

5

1    2

6

3    4

(C)

USE METAL COUPLING

1    5    2

3    6    4

(D)

USE METAL COUPLING (LARGE MAGNETIC FIELD)

1    5    2

3    6    4

# FIG. 17

(A)

(B)

$$\exp\left[M^{(0)}\sigma_1\sigma_2\sigma_3\sigma_4\right] = \Delta\sum_{d=\pm1}\exp\left[M^{(1)}(\sigma_1\sigma_2 + \sigma_3\sigma_4)d\right]$$

(C)

FIG. 18

1G

EP 4 589 663 A1

FIG. 19

BL

BL

1H

## FIG. 20

M

Bitline(BL)

BLS | BLS

TOX — | — CT

CG | CG

Charge spreading

⊖ ⊖ ⊖

Blocking layer

CG | CG

⊕ ⊕ Charge trap Si nitride

CG | CG

Source Line(SL)

BICS

(A)

M

Bitline(BL)

BLS | BLS

TOX — | — IPD

CG | CG

⊖⊖ ⊖⊖

⊖⊖ ⊖⊖

CG | CG

FG | FG

CG | CG

FG | FG

CG | CG

Source Line(SL)

DC-SF

(B)

FIG. 21

## INTERNATIONAL SEARCH REPORT

| International application No. |
|---|
| **PCT/JP2023/032697** |

**A. CLASSIFICATION OF SUBJECT MATTER**

*H01L 29/06*(2006.01)i; *G06N 10/40*(2022.01)i; *H01L 29/66*(2006.01)i; *H01L 29/82*(2006.01)i; *H10B 43/20*(2023.01)i; *H10B 99/00*(2023.01)i
   FI:   H01L29/06 601D; G06N10/40; H01L29/66 Z; H01L29/82 Z; H10B43/20; H10B99/00 451

According to International Patent Classification (IPC) or to both national classification and IPC

**B. FIELDS SEARCHED**

Minimum documentation searched (classification system followed by classification symbols)
   H01L29/06; G06N10/40; H01L29/66; H01L29/82; H10B43/20; H10B99/00

Documentation searched other than minimum documentation to the extent that such documents are included in the fields searched

   Published examined utility model applications of Japan 1922-1996
   Published unexamined utility model applications of Japan 1971-2023
   Registered utility model specifications of Japan 1996-2023
   Published registered utility model applications of Japan 1994-2023

Electronic data base consulted during the international search (name of data base and, where practicable, search terms used)

   JSTPlus/JMEDPlus/JST7580 (JDreamIII)

**C. DOCUMENTS CONSIDERED TO BE RELEVANT**

| Category* | Citation of document, with indication, where appropriate, of the relevant passages | Relevant to claim No. |
|---|---|---|
| X | JP 7-176763 A (SONY CORP) 14 July 1995 (1995-07-14) | 1 |
|   | paragraphs [0001], [0044]-[0049], fig. 1 |   |
| A | paragraphs [0001], [0044]-[0049], fig. 1 | 2-10 |
| A | JP 2021-197436 A (UNIV TEIKYO) 27 December 2021 (2021-12-27) | 1-10 |
|   | entire text, all drawings |   |
| A | JP 2000-40753 A (SONY CORP) 08 February 2000 (2000-02-08) | 1-10 |
|   | entire text, all drawings |   |
| A | US 2012/0280208 A1 (JAIN, Faquir Chand) 08 November 2012 (2012-11-08) | 1-10 |
|   | entire text, all drawings |   |
| A | TANAMOTO, Tetsufumi. Silicon quantum annealing machines using conventional CMOS devices. 2022 6th IEEE Electron Devices Technology & Manufacturing Conference (EDTM). 06 March 2022, pp. 226-228, DOI: 10.1109/EDTM53872.2022.9798162 | 1-10 |
|   | entire text, all drawings |   |

☐ Further documents are listed in the continuation of Box C.     ☑ See patent family annex.

| * Special categories of cited documents: | |
|---|---|
| "A" document defining the general state of the art which is not considered to be of particular relevance | "T" later document published after the international filing date or priority date and not in conflict with the application but cited to understand the principle or theory underlying the invention |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **01 November 2023** | **14 November 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

## INTERNATIONAL SEARCH REPORT
### Information on patent family members

International application No.

**PCT/JP2023/032697**

| Patent document cited in search report | | | Publication date (day/month/year) | Patent family member(s) | | | Publication date (day/month/year) |
|---|---|---|---|---|---|---|---|
| JP | 7-176763 | A | 14 July 1995 | US | 5608231 | A | |
| | | | | column 1, lines 10-12, column 9, line 23 to column 10, line 9, fig. 8 | | | |
| JP | 2021-197436 | A | 27 December 2021 | EP | 4167289 | A1 | |
| | | | | entire text, all drawings | | | |
| | | | | WO | 2021/251175 | A1 | |
| | | | | CN | 115699325 | A | |
| JP | 2000-40753 | A | 08 February 2000 | US | 6118686 | A | |
| | | | | entire text, all drawings | | | |
| US | 2012/0280208 | A1 | 08 November 2012 | US | 2016/0204202 | A1 | |
| | | | | entire text, all drawings | | | |
| | | | | US | 2018/0175241 | A1 | |
| | | | | US | 2020/0328277 | A1 | |
| | | | | US | 2022/0077221 | A1 | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022145376 A
- US 20160019468 A
- WO 2017182826 A
- JP 2021197436 A

**Non-patent literature cited in the description**

- **M. VELDHORST** ; **C. H. YANG** ; **J. C. C. HWANG** ; **W. HUANG** ; **J. P. DEHOLLAIN** ; **J. T. MUHONEN** ; **S. SIMMONS** ; **A. LAUCHT** ; **F. E. HUDSON** ; **K. M. ITOH**. A two-qubit logic gate in silicon. *nature*, 2015, vol. 526, 410-414
- **M. W. JOHNSON et al.** Quantum annealing with manufactured spins. *nature*, 2011, vol. 473, 194-198
- **S. MOCHIZUKI et al.** Stacked Gate-All-Around-nanosheetp FET with Highly Compressive Strained Si1-xGex Channel. *2020 IEEE International Electron Devices Meeting (IEDM)*, 2020, 2.3.1-2.3.4
- **T. TANAMOTO** ; **K. ONO**. Compact spin qubits using the common gate structure of fin field-effect transistors. *AIP Advances 11*, 2021, 045004
- **K. TAKEDA** ; **J. KAMIOKA** ; **T. OTSUKA** ; **J. YONEDA** ; **T.-NAKAJIMA** ; **M. R. DELBECQ** ; **S. AMAHA** ; **G. ALLISON** ; **T. KODERA** ; **S. ODA**. A fault-tolerant addressable spin qubit in a-natural silicon quantum dot. *Sci. Adv.*, 2016, vol. 2, e1600694
- **J. TAYLOR** ; **H.A. ENGEL et al.** Fault-tolerant architecture for quantum computation using electrically controlled semiconductor spins. *nature Phys*, 2005, vol. 1, 177-183
- **A. G. FOWLER** ; **A. C. WHITESIDE** ; **A. L. MCINNES** ; **A. RABBANI**. *Phys. Rev.*, 2012, vol. X 2, 041003
- **A. MATSUZAWA**. Low-voltage and low-power circuit design for mixed analog digital systems in portable equipment. *IEEE Journal of Solid-State Circuits*, 1994, vol. 29 (4), 470-480
- **N. YOSHIOKA** ; **Y. AKAGI** ; **H. KATSURA**. *Phys. Rev. E*, 2019, vol. 99, 032113